(19) Europäisches Patentamt / European Patent Office / Office européen des brevets

(11) **EP 4 390 545 A1**

(12) **EUROPEAN PATENT APPLICATION**
published in accordance with Art. 153(4) EPC

(43) Date of publication:
**26.06.2024 Bulletin 2024/26**

(21) Application number: **22858689.7**

(22) Date of filing: **12.08.2022**

(51) International Patent Classification (IPC):
***G03F 7/004*** *(2006.01)* ***G03F 7/105*** *(2006.01)*
***G03F 7/028*** *(2006.01)* ***G03F 7/032*** *(2006.01)*
***G02B 5/20*** *(2006.01)* ***H01L 27/146*** *(2006.01)*

(86) International application number:
**PCT/KR2022/012133**

(87) International publication number:
**WO 2023/022452 (23.02.2023 Gazette 2023/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.08.2021 KR 20210109222**

(71) Applicant: **Dongjin Semichem Co., Ltd.**
**Incheon 22824 (KR)**

(72) Inventors:
- **YOUN, Hyoc-Min**
**Hwaseong-si, Gyeonggi-do 18635 (KR)**
- **YEO, Tai Hoon**
**Hwaseong-si, Gyeonggi-do 18635 (KR)**
- **LEE, Sang-Hoon**
**Hwaseong-si, Gyeonggi-do 18635 (KR)**
- **JANG, Jae Young**
**Hwaseong-si, Gyeonggi-do 18635 (KR)**
- **HWANG, Chi Yong**
**Hwaseong-si, Gyeonggi-do 18635 (KR)**

(74) Representative: **Grünecker Patent- und Rechtsanwälte**
**PartG mbB**
**Leopoldstraße 4**
**80802 München (DE)**

(54) **PHOTOSENSITIVE RESIN COMPOSITION AND DISPLAY DEVICE**

(57) The present invention relates to a photosensitive resin composition that not only has excellent optical density and light resistance, but also has improved transmittance, photoreactivity, and sensitivity, and thus can be preferably applicable to form a pixel defining layer pattern of various display devices, such as an organic electroluminescent device, and a display device manufactured using the same.

EP 4 390 545 A1

## Description

[TECHNICAL FIELD]

The present invention relates to a photosensitive resin composition that not only has excellent optical density and light resistance, but also has improved transmittance, photoreactivity, and sensitivity, and thus can be preferably applicable to form a pixel defining layer pattern of various display devices, such as an organic electroluminescent device, and a display device manufactured using the same.

### [BACKGROUND]

Recently, organic electroluminescent devices have been widely applied as display devices in various electronic devices to which thin displays are applied, such as smartphones, tablet PCs, and TVs.

Such an organic electroluminescent device generally has a structure in which a translucent first electrode formed on the light extraction side and a non-transmissive second electrode formed on the other side are formed on a substrate, and an organic light emitting layer in which each pixel of red, green, blue, etc. is defined is formed between first and second electrodes. Further, a pixel defining layer pattern is formed between each pixel to divide and define these pixels, and such a pixel defining layer pattern is usually formed as a barrier rib pattern having an inverted taper structure.

Such a pixel defining layer pattern is generally formed using a photosensitive resin composition containing a black pigment in order to prevent a decrease in visibility and contrast of the display device due to reflection of external light. When a pixel defining layer pattern is formed with such a black pigment-containing photosensitive resin composition, the pixel defining layer pattern exhibits high light-shielding properties and can suppress reflection of external light, whereby display devices such as organic electroluminescent devices can exhibit excellent visibility.

Typically, it has previously been known that the pixel defining layer pattern can be formed using a photosensitive resin composition which comprises an alkali-soluble resins such as a polyimide resin having a photocurable functional group, a black pigment, a polyfunctional compound having a photocurable functional group, and photoinitiator.

By the way, when forming barrier rib and pixel defining layer patterns using such conventional photosensitive resin compositions, there was a drawback that the finally formed barrier rib pattern, etc. exhibit inferior optical density and light resistance, whereby the photostability of the pixel defining layer pattern is not sufficient. In addition, there was also a problem that the overall light transmittance of the photosensitive resin composition is reduced due to the action of the black pigment, resulting in deterioration of photoreactivity and sensitivity.

In addition, a pixel defining layer pattern formed using a conventional photosensitive resin composition has insufficient residual film characteristics, adhesive force to substrates, etc., and/or reliability. Therefore, there is a continuing need to develop a photosensitive resin composition that can improve the overall characteristics of the pixel defining layer pattern.

### [DETAILED DESCRIPTION OF THE INVENTION]

### [Technical Problem]

It is an object of the present invention to provide a photosensitive resin composition that not only has excellent optical density and light resistance, but also has improved transmittance, photoreactivity, and sensitivity, and thus can be preferably applicable to form a pixel defining layer pattern of various display devices, such as an organic electroluminescent device.

It is another object of the present invention to provide a display device which comprises a pixel defining layer pattern using the cured film formed from the photosensitive resin composition, and thus exhibits not only excellent light resistance and photostability, but also excellent residual film characteristics, adhesive force, and reliability.

### [Technical Solution]

In one aspect of the present invention, there is provided a photosensitive resin composition comprising:

an alkali-soluble resin;
a polyfunctional compound having a plurality of photocurable unsaturated functional groups;
a pigment including a black pigment or a pigment mixture exhibiting a black color in a mixture state; and
a photoinitiator,
wherein the alkali-soluble resin is a resin having a repeating unit derived from a phenolic compound having two or

more phenolic hydroxy groups, and a plurality of photocurable unsaturated functional groups at both ends of the main chain.

In another aspect of the present invention, there is provided a display device comprising:

a substrate;
red, green and blue pixels defined on the substrate; and
a pixel defining layer pattern that is formed between the pixels, and includes a cured film of the photosensitive resin composition.

In such a display device, the cured film may comprise,

an alkali-soluble resin that is cured and crosslinked through the photocurable unsaturated functional group of the polyfunctional compound, and
a pigment including a black pigment or a pigment mixture that represents a black color dispersed in the cured and crosslinked alkali-soluble resin.

**[Advantageous Effects]**

The photosensitive resin composition described herein has a repeating unit structure derived from a phenolic compound having a specific structure, and includes an alkali-soluble resin having a plurality of photocurable unsaturated functional groups.

As the photosensitive resin composition includes such a specific alkali-soluble resin, it enables the formation of a cured film that exhibits excellent optical density and light resistance. Further, despite the inclusion of a black pigment or a pigment mixture exhibiting a black color, the photosensitive resin composition can exhibit significantly improved light transmittance, photoreactivity, and sensitivity, thereby enabling formation of excellent barrier rib and pixel defining layer pattern even under exposure conditions of relatively small amount of light.

In addition, the pixel defining layer pattern formed from the photosensitive resin composition can exhibit excellent reliability, adhesive force, and residual film characteristics, and therefore can be very preferably applied to form a pixel defining layer pattern that defines pixels of various display devices such as organic electroluminescent devices.

[BRIEF DESCRIPTION OF THE DRAWINGS]

FIG. 1 shows an ITO substrate including a patterned cured film and deposited EL and Al for reliability evaluation.

[DETAILED DESCRIPTION OF THE EMBODIMENTS]

The present invention will be described in more detail below. Terms or words used in the present specification and claims should not be construed as limited to ordinary or dictionary terms, and the present invention should be construed with meanings and concepts that are consistent with the technical idea of the present invention based on the principle that the inventors may appropriately define concepts of the terms to appropriately describe their own invention in the best way.

The terms "comprise," "include", "have", etc. are used herein to specify the presence of stated feature, region, integer, step, action, element and/or component, but do not preclude the presence or addition of other feature, region, integer, step, action, element and/or component.

As used herein, the (meth)acrylate is intended to include both acrylate and methacrylate.

Further, as used herein, "(repeating) unit derived" from a phenolic compound, etc. may collectively refer to any unit linking structure, repeating structure or unit structure of a polymer (or resin), which can be formed by reacting a phenolic compound with another compound or by polymerizing the phenolic compound itself.

Hereinafter, exemplary embodiments of the present invention will be described in detail so that those skilled in the art can easily carry out them. The present invention can be modified in various different ways, and is not limited to the embodiments set forth herein.

According to one embodiment of the present invention, there is provided a photosensitive resin composition comprising:

an alkali-soluble resin;
a polyfunctional compound having a plurality of photocurable unsaturated functional groups;
a pigment including a black pigment or a pigment mixture exhibiting a black color in a mixture state; and

a photoinitiator,
wherein the alkali-soluble resin is a resin having a repeating unit derived from a phenolic compound having two or more phenolic hydroxy groups, and a plurality of photocurable unsaturated functional groups at both ends of the main chain.

The photosensitive resin composition of one embodiment comprises an alkali-soluble resin having a repeating unit structure derived from a phenolic compound that has a plurality of phenolic hydroxy groups and contains a ring structure such as an aromatic ring. In a specific example, the repeating unit may include three or more ring structures of aromatic rings and/or optionally alicyclic rings. In a more specific example, at least a part of the aromatic ring may have 1 or 2 phenolic hydroxy groups, and the repeating unit has 2 to 6 aromatic rings and 0 to 4 alicyclic rings in the molecule, and thus may have 3 or more, or 3 to 6, or 3 to 5 phenolic hydroxy groups, as a whole.

Further, in such an alkali-soluble resin, a plurality of photocurable unsaturated functional groups capable of causing a curing reaction upon exposure to light are bonded to at least both ends of the main chain. In a specific example, the photocurable unsaturated functional group may be, for example, bonded to a repeating unit derived from a phenolic compound through an ether (-O-) linking group derived from a phenolic hydroxy group.

It was confirmed that as the photosensitive resin composition includes an alkali-soluble resin having the above-mentioned structure, it can exhibit greatly improved light transmittance, photoreactivity with a photoinitiator, etc. and sensitivity, despite the inclusion of a black pigment or a pigment mixture exhibiting a black color. This appears to be because the conjugation structure due to the inclusion of an aromatic ring and optionally an alicyclic ring can improve the light transmittance of the photosensitive resin composition. Therefore, the photosensitive resin composition of one embodiment enables the formation of excellent barrier rib and pixel defining layer pattern even under exposure conditions of relatively small amount of light.

Further, it was confirmed that due to the interaction of the alkali-soluble resin and the black pigment or pigment mixture, the cured film formed from the photosensitive resin composition of one embodiment may exhibit excellent optical density and light resistance.

Further, the alkali-soluble resin may have a polystyrene-converted weight average molecular weight (Mw) of at least 1,000 or more, or 2,000 to 30,000. Thereby, the photosensitive resin composition can be further improved in the above-mentioned light transmittance, sensitivity, photoreactivity, and light resistance.

Unlike the same, when the structure of the alkali-soluble resin, for example, the ring structure or the number of phenolic hydroxy groups, or the weight average molecular weight range is outside the above-mentioned range, it was confirmed that the sensitivity, light transmittance or the like of the composition may be reduced, or the optical density and light resistance may be reduced, so that the adhesive force and residual film characteristics of the cured film, barrier rib, and pixel defining layer pattern formed from the photosensitive resin composition can be significantly reduced.

Unlike the same, when the photosensitive resin composition of one embodiment is used, it is possible to form a pixel defining layer pattern that exhibits excellent reliability, light resistance, adhesive force, residual film characteristics, and the like. Therefore, the composition of one embodiment can be very preferably applicable to form a pixel defining layer pattern that defines pixels of various display devices, such as an organic electroluminescent device.

Now, the photosensitive resin composition of one embodiment will be described in more detail for each component.

First, the composition of one embodiment includes a predetermined alkali-soluble resin. This alkali-soluble resin has a ring structure such as an aromatic ring in the molecule, and contains a phenolic-derived repeating unit having two or more, or three or more phenolic hydroxy groups. According to a specific example, the repeating unit may have 3 or more, or 3 to 8, or 3 to 7 ring structures of an aromatic ring and optionally an alicyclic ring, and may have 3 or more phenolic hydroxy groups, as a whole.

In a more specific example, at least a part of the aromatic rings may have one or two phenolic hydroxy groups, the repeating unit has 2 to 6 aromatic rings and 0 to 4 alicyclic rings in the molecule, and thus may have a total of 3 or more, or 3 to 6, or 3 to 5 phenolic hydroxy groups, as a whole.

The repeating unit derived from such a phenol-based compound has a structure in which the phenolic hydroxy group of the phenol-based compound is polymerized in an epoxidized state as confirmed in specific examples described later. Such a repeating unit can be bonded to a photocurable unsaturated functional group through an ether (-O-) linkage group derived from the phenolic hydroxy group, or the like, and such photocurable unsaturated functional groups may be bonded to at least both ends of the main chain of the alkali-soluble resin.

In a more specific example, the repeating unit has a structure in which a plurality of photocurable unsaturated functional groups, for example, a (meth)acrylate-based functional group, are bonded to at least a part of the epoxidized phenolic hydroxy group, and simultaneously may have, for example, a structure in which an alkali-soluble functional group selected from the group consisting of hydrogen, a hydroxy group, an alkoxy group having 1 to 5 carbon atoms, a carbonyl group, a carboxy group, and the like is directly bonded, or such an alkali-soluble functional group-containing substituent is bonded.

As the alkali-soluble resin has repeating units derived from a specific phenolic compound, the composition of one embodiment may exhibit improved light transmittance and sensitivity, and may exhibit excellent photoreactivity with a polyfunctional compound under the mediation of a photoinitiator. Thereby, it is possible to form a cured film that is excellent in light resistance and optical density, as well as various properties such as adhesive force and residual film characteristics.

In addition, the photocurable unsaturated functional group contained in the alkali-soluble resin can be photocured with the photocurable unsaturated functional group of the polyfunctional compound under the mediation of a photoinitiator in the exposed part, and thus no longer has alkali solubility and can remain in the barrier rib and pixel defining layer patterns.

In addition, due to the presence of alkali-soluble functional groups in the resin, the photosensitive resin composition can be developed and removed in the unexposed part by an alkaline developer, for example, an aqueous tetramethylammonium hydroxide solution. More specifically, the alkali-soluble resin can be developed and removed in the unexposed part by the alkaline developer, for example, a 2.38 wt.% tetramethylammonium hydroxide aqueous solution, at a development rate of 200 to 2,000 Å/sec.

The alkali-soluble resin having the above-mentioned structural characteristics may have, for example, a structure of the following General Formula 1:

<General Formula 1> (AB)-(ZBA)p-(BA)

wherein, in General Formula 1, A is a photocurable unsaturated functional group, each B is independently an organic group including an alkali-soluble functional group selected from the group consisting of hydrogen, a hydroxy group, an alkoxy group having 1 to 5 carbon atoms, a carbonyl group and a carboxyl group, Z is a repeating unit derived from a phenolic compound having two or more phenolic hydroxy groups, and p is an integer of 2 to 100.

In a more specific example, the above-mentioned alkali-soluble resin may comprise one or more selected from the group consisting of the following Chemical Formulas 1 and 2:

[Chemical Formula 1]

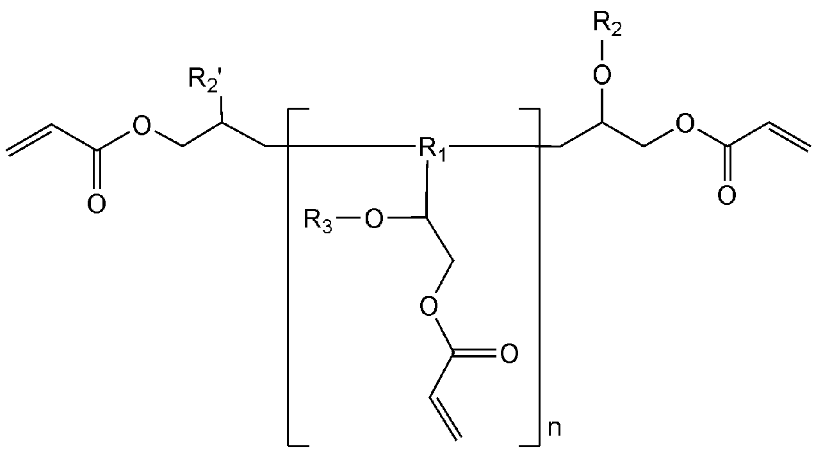

[Chemical Formula 2]

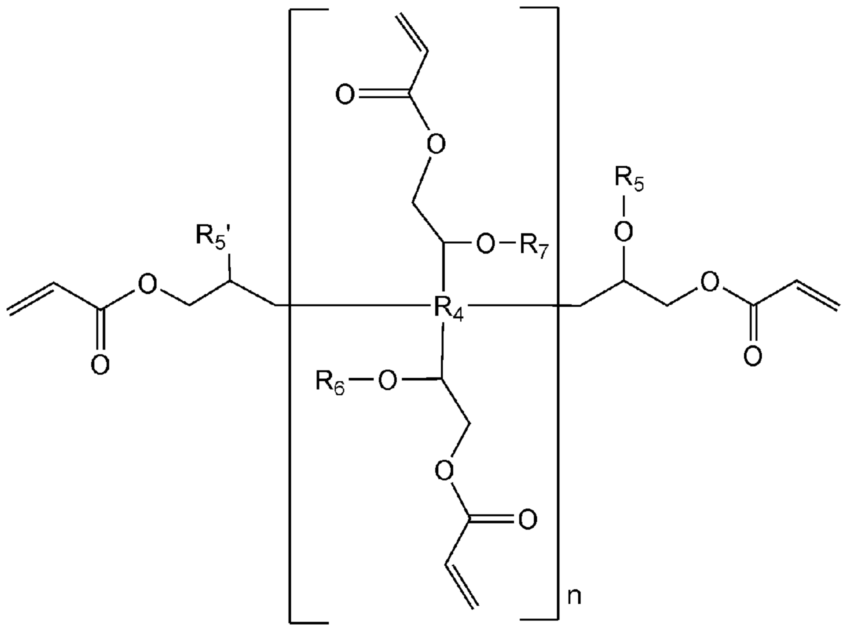

wherein, in Chemical Formulas 1 and 2,

$R_1$ and $R_4$ each independently represent a functional group derived from a phenolic compound having 3 to 8 aromatic rings or alicyclic rings in the molecule and having 3 or more phenolic hydroxy groups,

$R_2$, $R_3$, $R_5$, $R_6$ and $R_7$ each independently represent a substituent including an alkali-soluble functional group selected from the group consisting of hydrogen, a hydroxy group, an alkoxy group having 1 to 5 carbon atoms, a carbonyl group, and a carboxy group,

$R_2$' and $R_5$' are each independently hydrogen or ORs, where $R_8$ each independently represents a substituent including an alkali-soluble functional group selected from the group consisting of hydrogen, a hydroxy group, an alkoxy group having 1 to 5 carbon atoms, a carbonyl group, and a carboxyl group, and

n is the number of repetitions and represents an integer of 2 to 100.

Further, the $R_2$, $R_3$, $R_5$, $R_6$ and $R_7$ of Chemical Formulas 1 and 2 may each independently include one or more alicyclic structures. For example, the $R_2$, $R_3$, $R_5$, $R_6$ and $R_7$ of Chemical Formulas 1 and 2 may each independently include one to three alicyclic structures. In a more specific example, the repeating unit included in the alkali-soluble resin may include a functional group (linking structure) derived from a specific phenolic compound. Specific examples of the $R_1$ and $R_4$ as such functional groups (connected structures) include functional groups (linking structure) derived from phenolic compounds selected from the group consisting of the following Chemical Formulas 3 to 17:

[Chemical Formula 3]

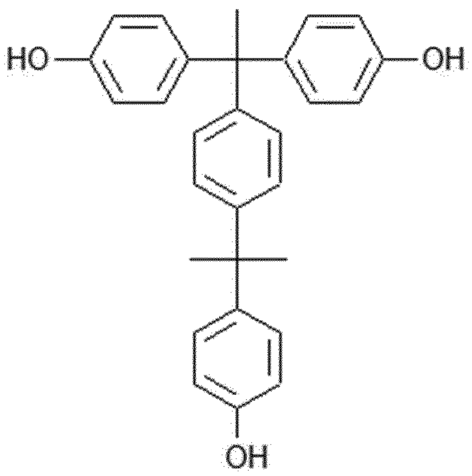

[Chemical Formula 4]

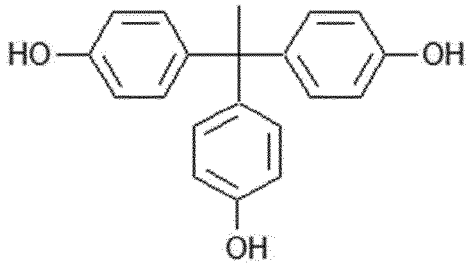

[Chemical Formula 5]

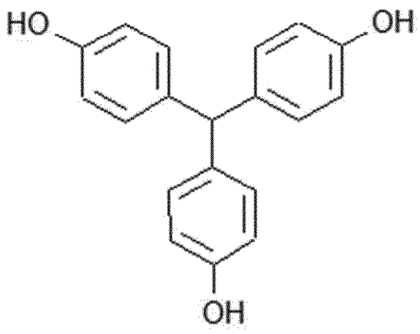

[Chemical Formula 6]

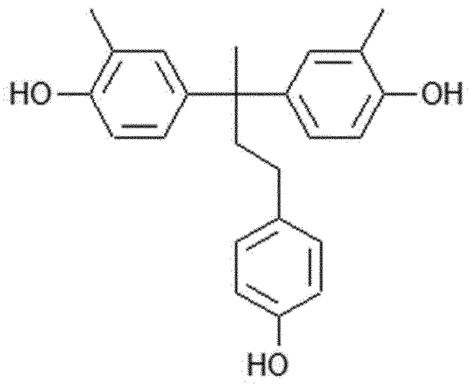

[Chemical Formula 7]

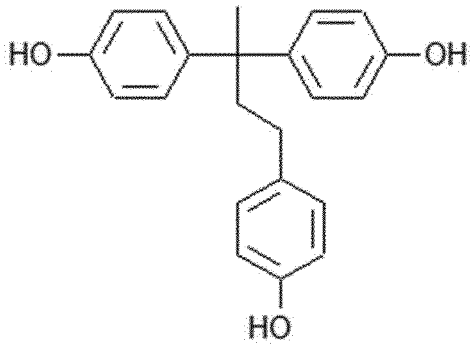

[Chemical Formula 8]

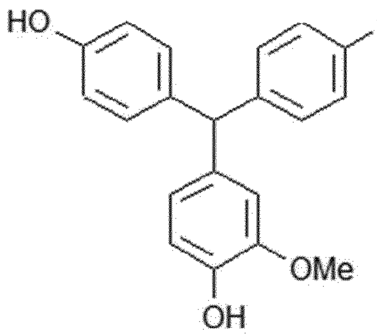

[Chemical Formula 9]

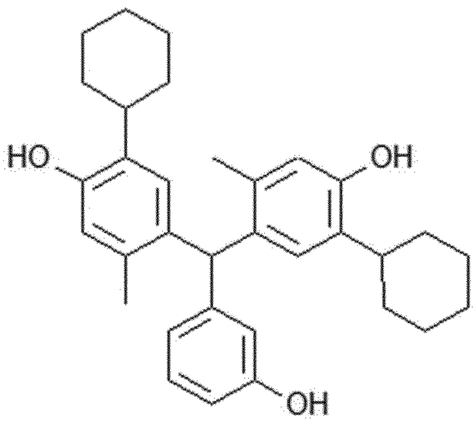

[Chemical Formula 10]

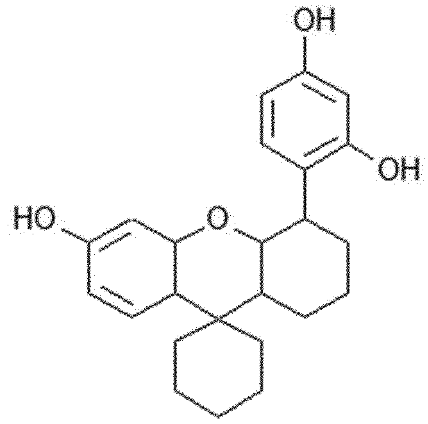

[Chemical Formula 11]

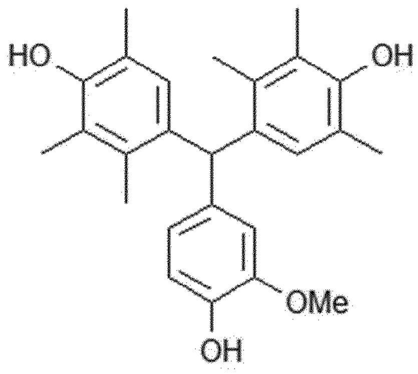

[Chemical Formula 12]

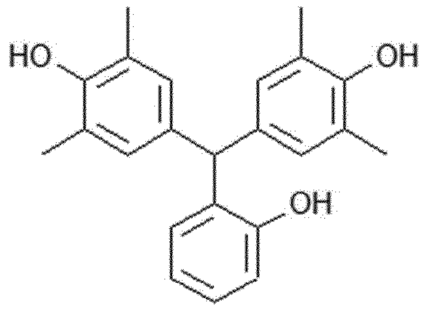

[Chemical Formula 13]

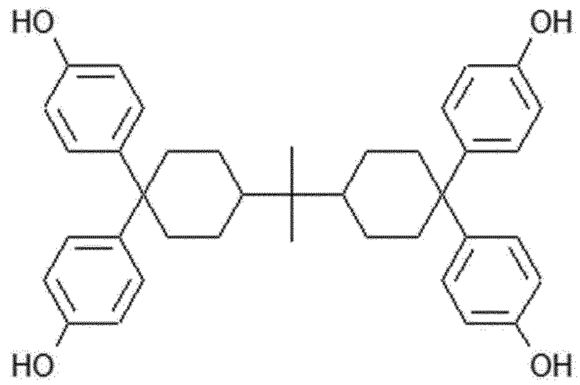

[Chemical Formula 14]

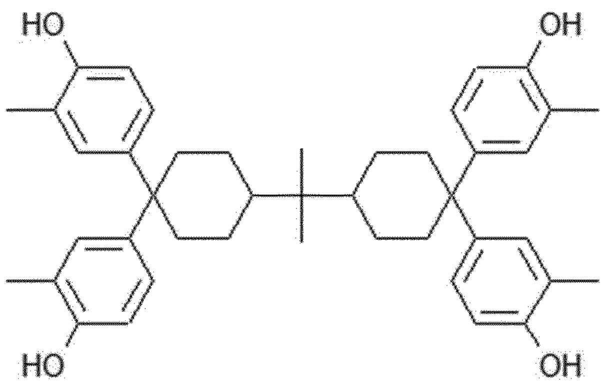

[Chemical Formula 15]

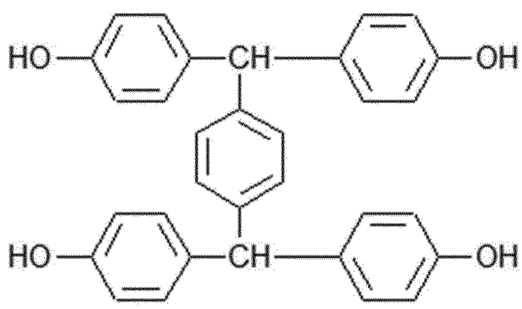

[Chemical Formula 16]

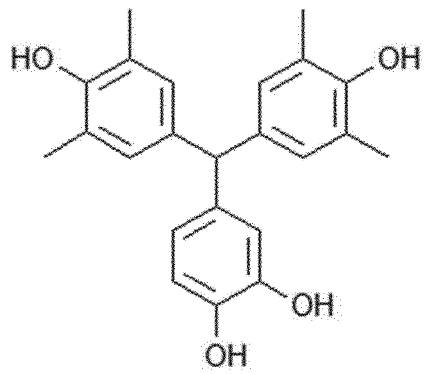

[Chemical Formula 17]

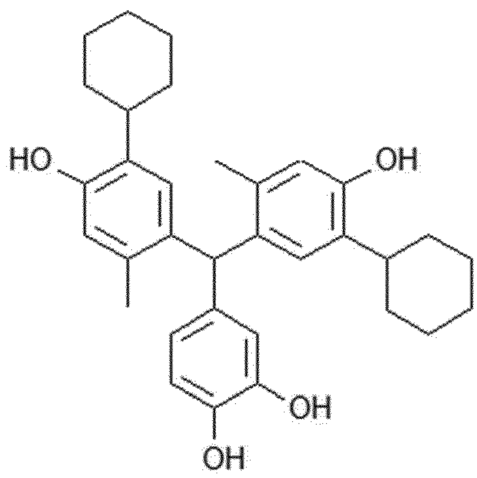

Specific examples of the above-mentioned alkali-soluble resin may include one or more selected from the group consisting of the following Chemical Formulas 3A to 17A. In addition, it goes without saying that it may also have various structures encompassed by Chemical Formulas 1 or 2:

[Chemical Formula 3A]

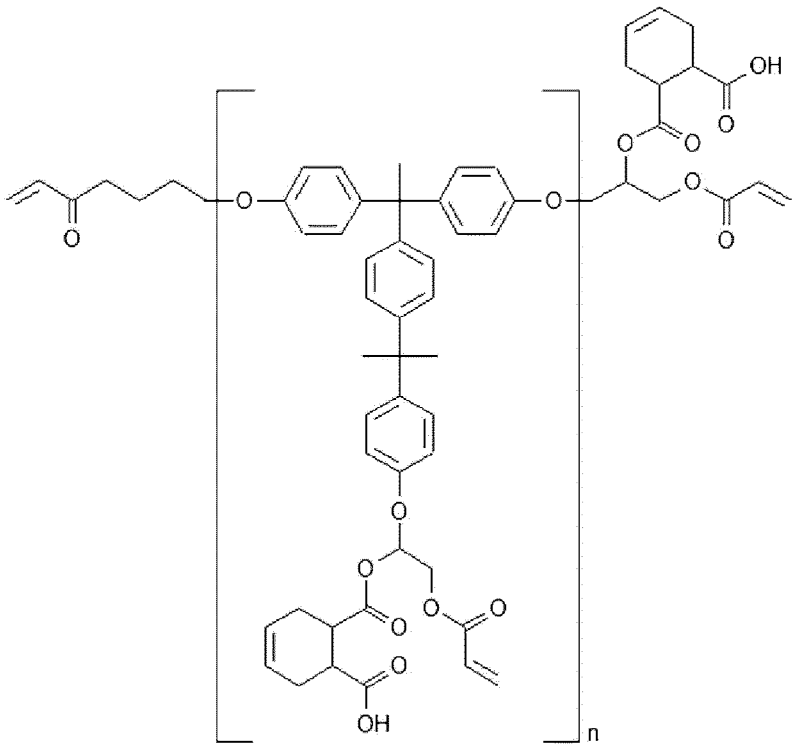

[Chemical Formula 4A]

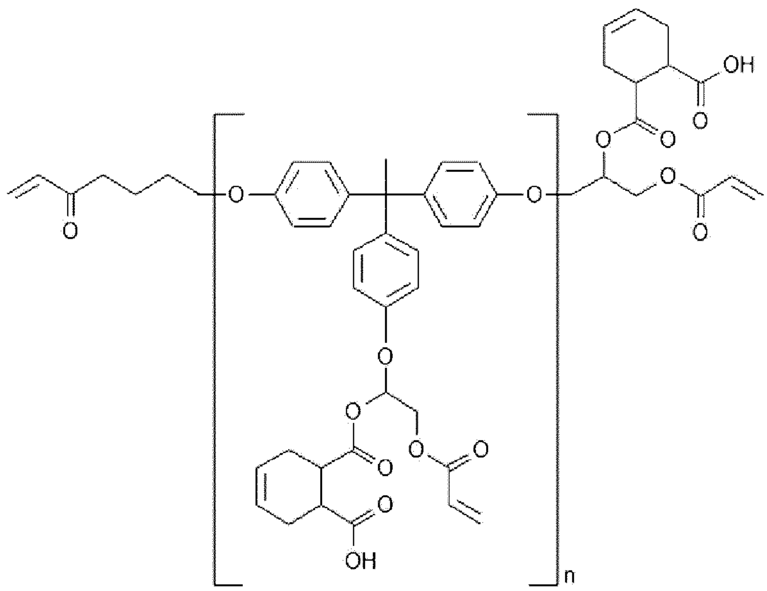

[Chemical Formula 5A]

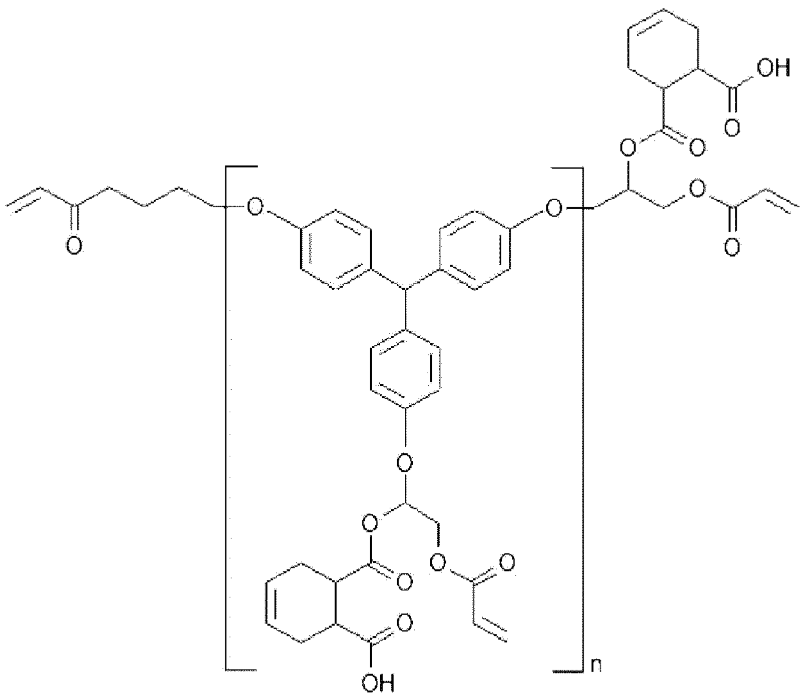

[Chemical Formula 6A]

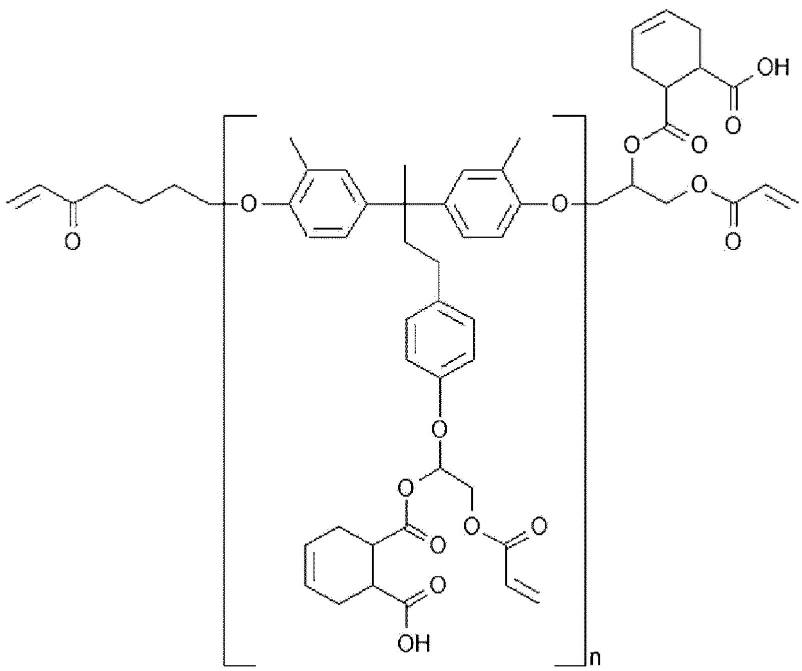

[Chemical Formula 7A]

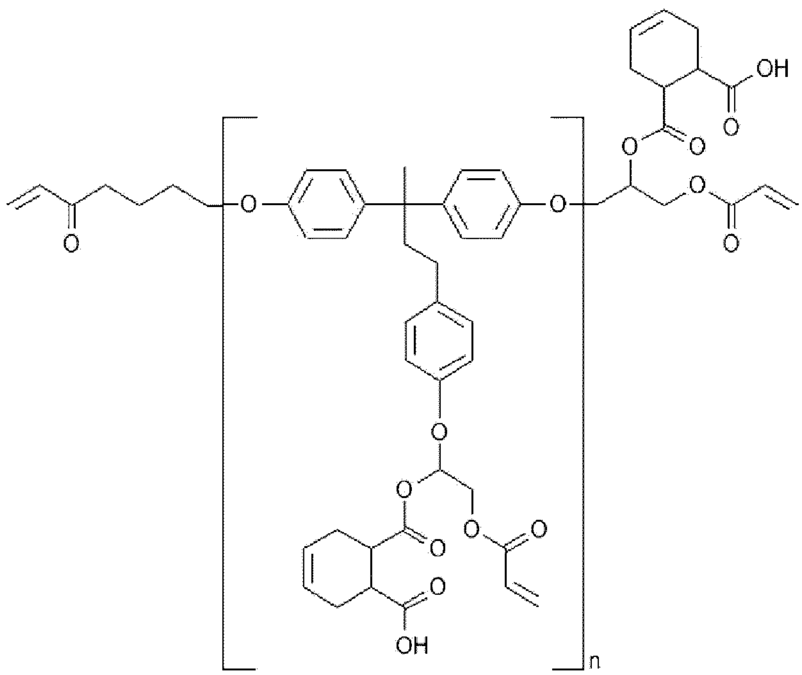

[Chemical Formula 8A]

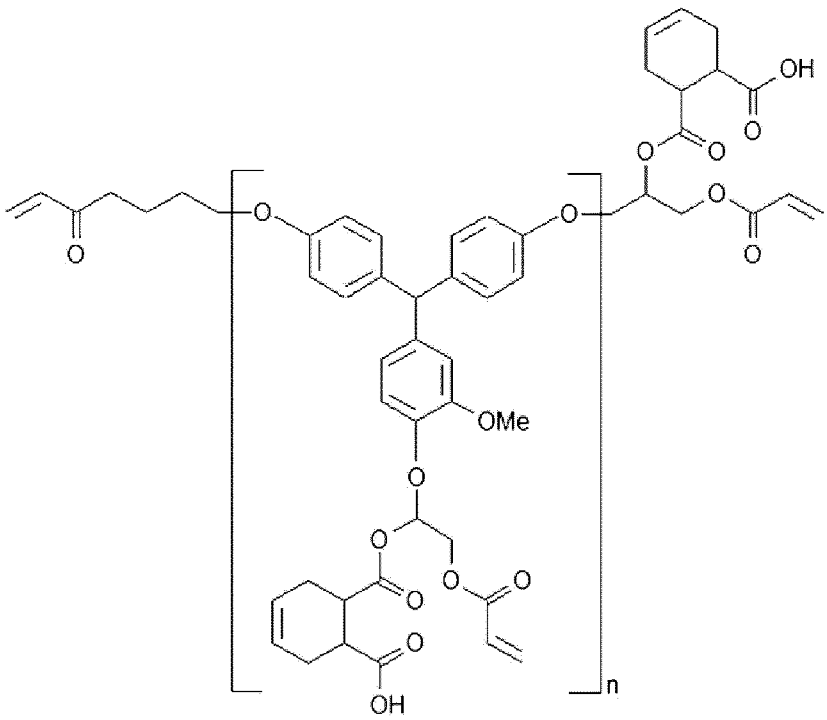

[Chemical Formula 9A]

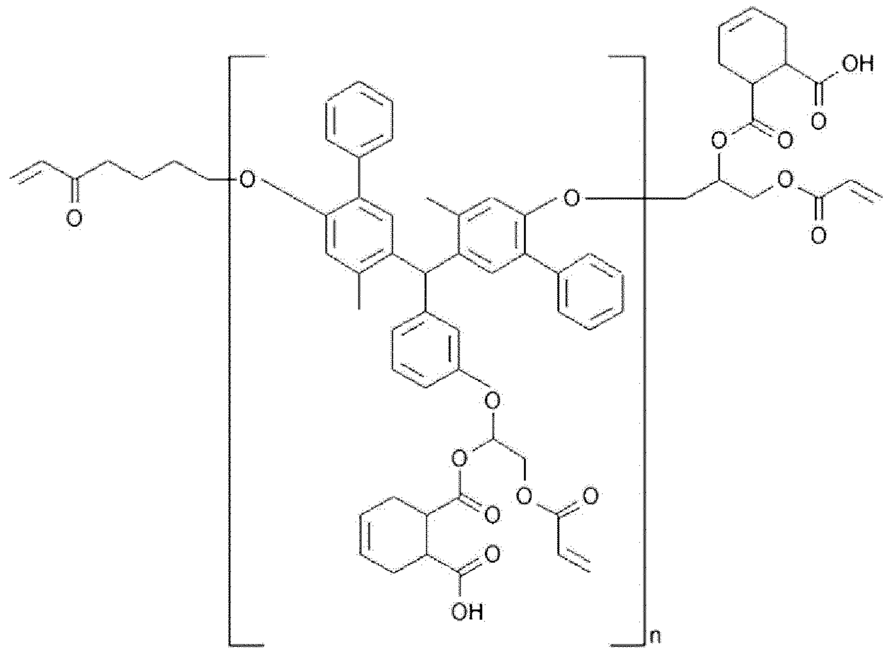

[Chemical Formula 10A]

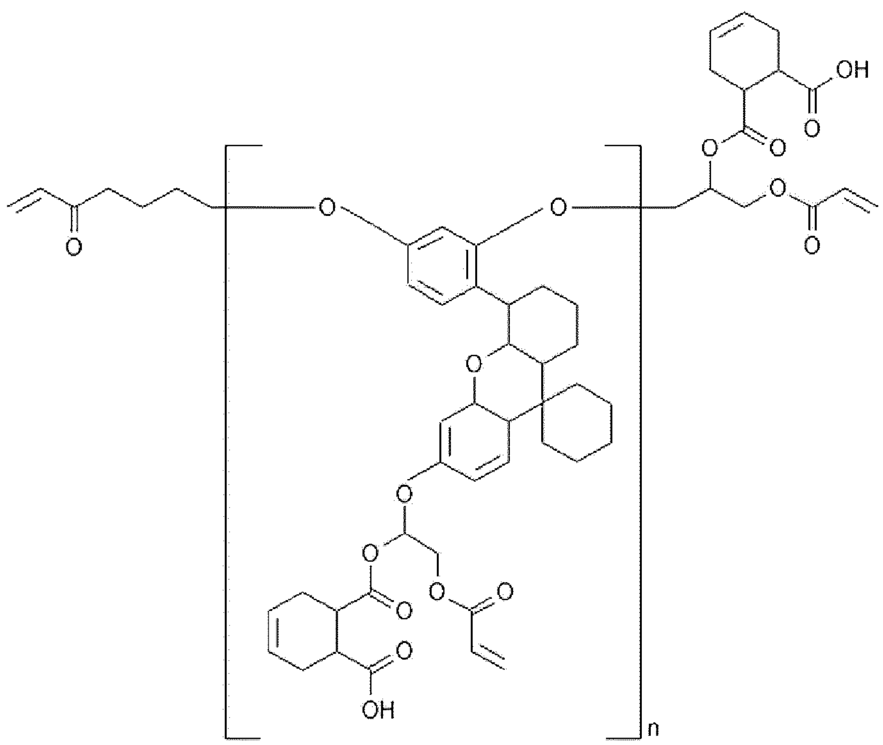

[Chemical Formula 11A]

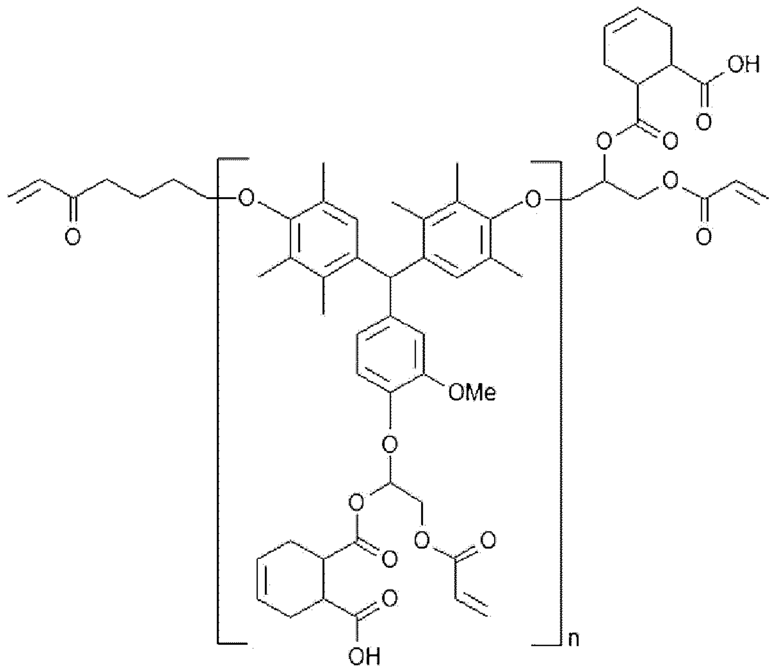

[Chemical Formula 12A]

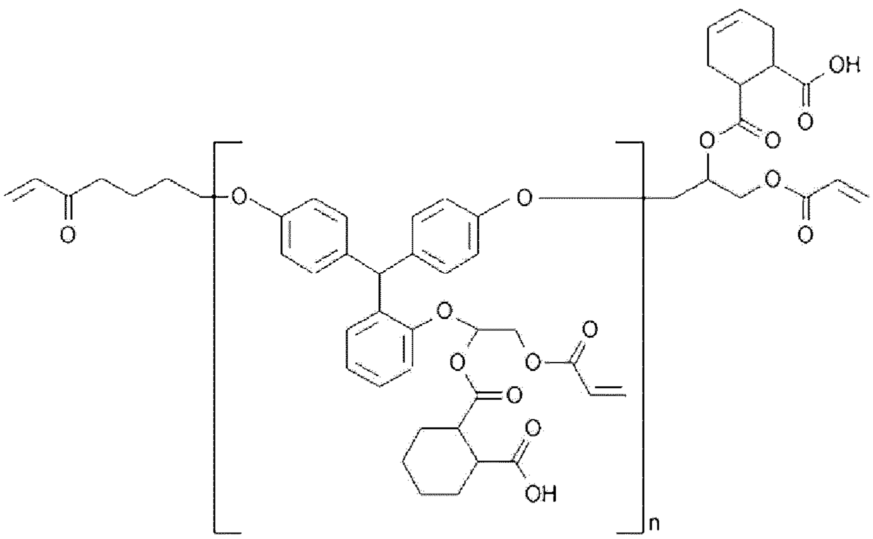

[Chemical Formula 13A]

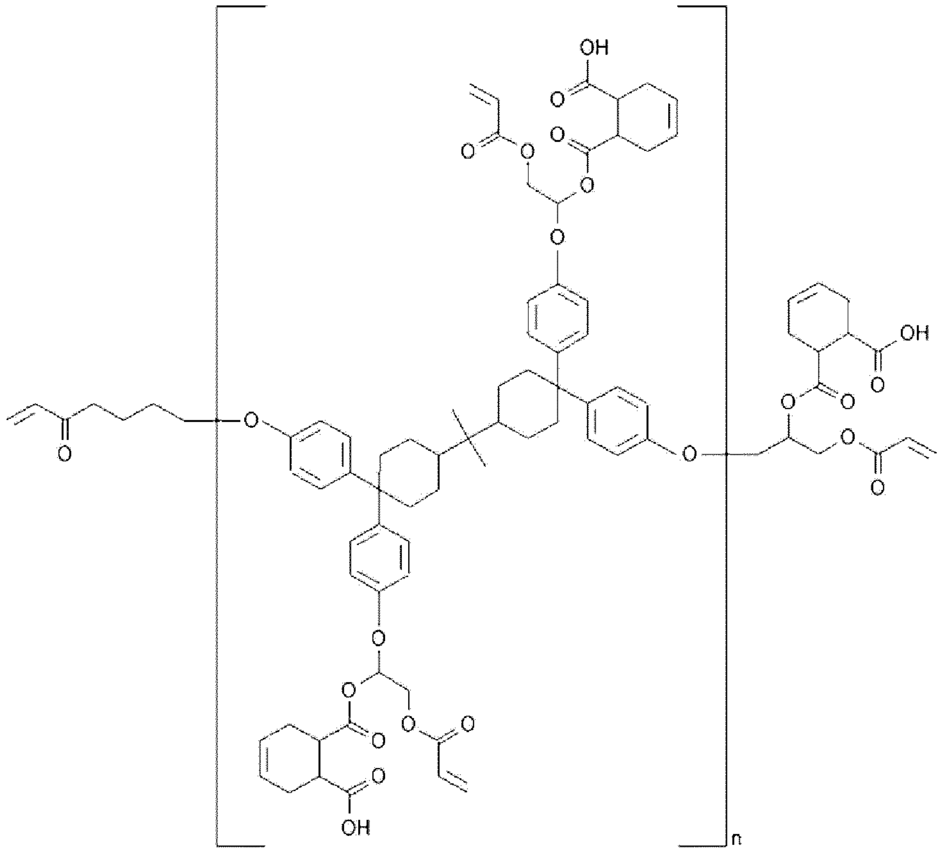

[Chemical Formula 14A]

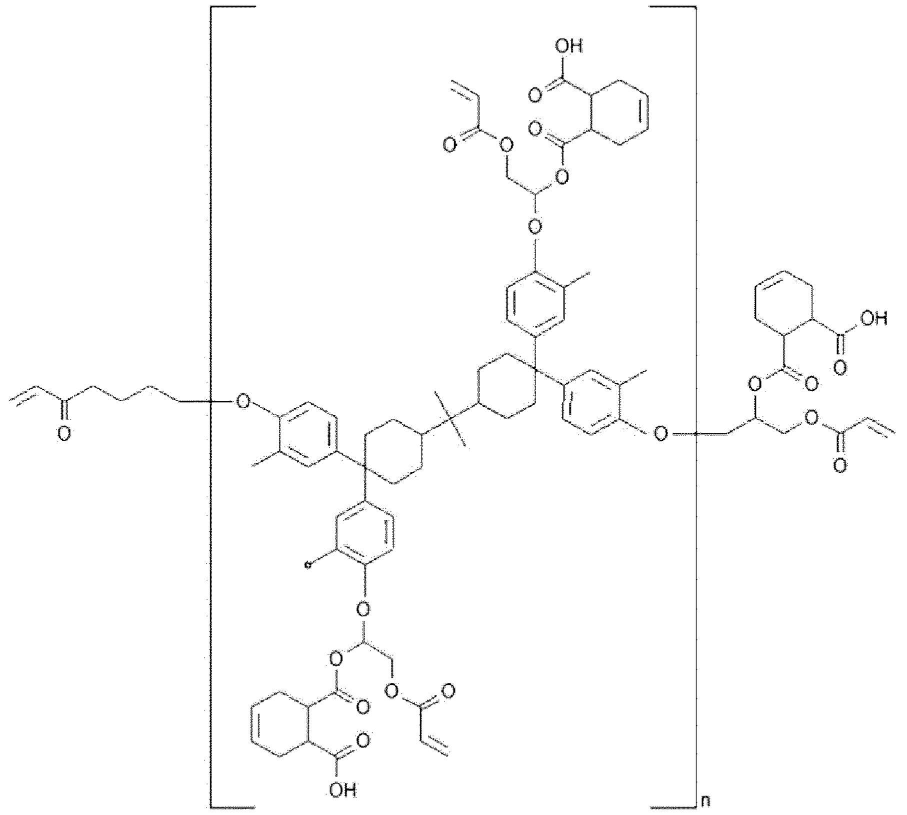

[Chemical Formula 15A]

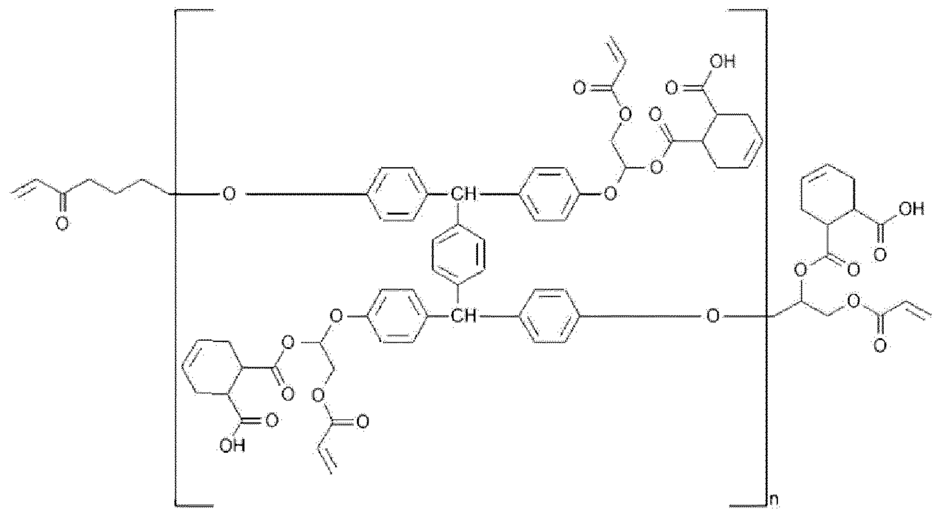

[Chemical Formula 16A]

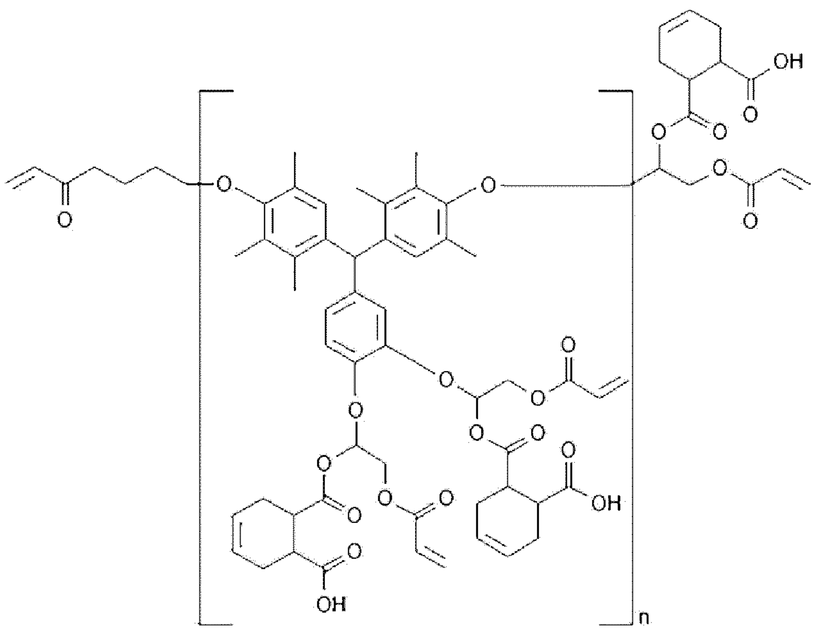

[Chemical Formula 17A]

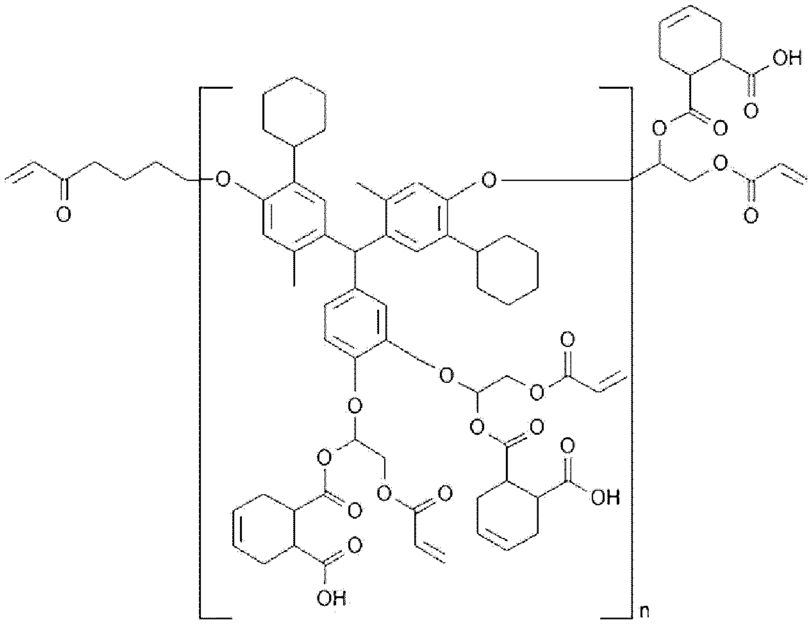

wherein, in Chemical Formula 3A to 17A, n is the number of repetitions and represents an integer of 2 to 100.

Meanwhile, as the degree of polymerization of the above-mentioned alkali-soluble resin is adjusted to have a polystyrene-converted weight average molecular weight of 1,000 or more, or 2,000 to 30,000, or 2,000 to 20,000, the composition of one embodiment can be further improved in light transmittance, sensitivity, and photoreactivity, and a cured film formed from the composition of one embodiment, etc. can be further improved in light resistance, optical density, adhesive force, and residual film characteristics. If this weight average molecular weight is outside the above-mentioned range, the sensitivity or photoreactivity of the alkali-soluble resin may decrease, the residual film characteristics or adhesive force of the cured film may deteriorate, or the light resistance may become insufficient.

In addition, the above-mentioned alkali-soluble resin can be produced by a method comprising: a step of reacting the above-mentioned phenolic compound with an epoxidizing agent such as epichlorohydrin to epoxidize at least a part of the phenolic hydroxy group; a step of polymerizing the epoxidized compound to have a degree of polymerization of n; a step of reacting the polymer with a (meth)acrylic acid or a derivative thereof to bind a photocurable unsaturated

functional group such as a (meth)acrylate-based functional group to at least a part of the epoxidized phenolic hydroxy group; and optionally, a step of introducing an alkali-soluble functional group into a polymer (resin) to which the photocurable unsaturated functional group is bonded.

Herein, the epoxidizing agent may be added and used at an equivalent weight that is equal to or less than the phenolic hydroxy group. If the equivalent weight of the epoxidizing agent added is higher than the phenolic hydroxy group, no residual hydroxyl groups remain and the polymerization process may not proceed properly. Further, in the polymerization step, a preferable degree of polymerization and weight average molecular weight of the alkali-soluble resin can be achieved by controlling the polymerization temperature and time.

Meanwhile, the progress of each of the above-mentioned reaction steps may depend on normal epoxidation reaction conditions, polymerization conditions, (meth)acrylation reaction conditions, and the like, and the specific reaction conditions and progress methods are described in Preparation Examples described later, and thus, further description thereof will be omitted.

Meanwhile, the photosensitive resin composition of one embodiment includes a polyfunctional compound having a plurality of photocurable unsaturated functional groups. Such a polyfunctional compound may cause a photocuring reaction with the above-mentioned alkali-soluble resin in the exposed part of the photosensitive resin composition under the mediation of a photoinitiator to form a crosslinked structure, and can define a barrier rib and a pixel defining layer pattern that are not removed by the developer.

Such a polyfunctional compound may have various photocurable unsaturated functional groups, and may more suitably have the same type of unsaturated functional group as the above-mentioned alkali-soluble resin, for example, a (meth)acrylate-based functional group.

In a more specific example, the polyfunctional compound may be a monomer or oligomer having 2 to 20 (meth)acrylate-based functional groups, and for example, one or more selected from the group consisting of a (meth)acrylate-based compound such as an alkyl (meth)acrylate-based compound or a hydroxy (meth)acrylate-based compound, an aliphatic urethane (meth)acrylate-based compound, an aromatic urethane (meth)acrylate-based compound, and an epoxy (meth)acrylate-based compound may be used.

More specific examples of such polyfunctional compounds include one or more selected from the group consisting of dipentaerythritol hexaacrylate, dipentaerythritol pentaacrylate, ditrimethylolpropane tetraacrylate, trimethylolpropane triacrylate, tricyclodecane dimethanol diacrylate and 1,6-hexanediol diacrylate.

However, the type of the polyfunctional compound is not particularly limited, and any polyfunctional compound, such as a polyfunctional (meth)acrylate compound that have previously been known to be usable in photosensitive resin compositions or are commercially available, can be used without particular limitation.

Meanwhile, the photosensitive resin composition of one embodiment includes a pigment including a black pigment or a pigment mixture exhibiting a black color in a mixture state. Such a black pigment or pigment mixture is included in order to improve visibility or contrast of the display device by suppressing light reflection of the photosensitive resin composition and the cured film. In addition, by including such a black pigment or the like, the light resistance and optical density of a cured film formed from the composition can be further improved.

As the black pigment, either an organic black pigment or an inorganic black pigment can be used. For example, one or more black pigments selected from the group consisting of aniline black, perylene black, titanium black, cyanine black, lignin black, lactam-based black, and carbon black can be used without particular limitation.

Further, the pigment may include a pigment mixture in which a plurality of pigments having different colors are mixed to exhibit a black color as a whole. According to a more specific example, such a pigment mixture includes two or more selected from red pigment, blue pigment, yellow pigment, green pigment and violet pigment, and may exhibit a black color in a mixture state as a whole.

Herein, specific examples of pigments having different colors for obtaining the pigment mixture may include one or more selected from the group consisting of C.I. Pigment Yellow, C.I. Pigment Red, C.I. Pigment Violet, C.I. Pigment Blue and C.I. Pigment Green. In addition, it goes without saying that various additional pigments can also be used. That is, a plurality of pigments having different colors are mixed according to a mixing ratio obvious to those skilled in the art to obtain a pigment mixture exhibiting a black color as a whole, which can be included in the composition of one embodiment.

Meanwhile, it goes without saying that in addition to the black pigment or pigment mixture described above, additional pigments having different colors as described above may be further included.

The pigment containing the black pigment or pigment mixture described above may be a particulate pigment having a particle size of 100 to 200 nm. By using a pigment with such a fine particle size, the light resistance and visibility of the display device can be further improved.

Further, the pigment may be mixed with other components in the form of a pigment dispersion dispersed in an organic solvent, for example, one or more organic solvents selected from the group consisting of propylene glycol methyl ether, gamma butyrolactone, propylene glycol methyl ether acetate, and ethyl lactate, so that the pigment can be appropriately mixed with other components and uniformly dispersed or dissolved.

Meanwhile, the composition of one embodiment further includes a photoinitiator. Such a photoinitiator can initiate and promote the photocuring and crosslinking reaction between the alkali-soluble resin and the polyfunctional compound in the exposed part.

As such a photoinitiator, any photoinitiator that has been known to be usable in photosensitive resin compositions can be used without particular limitation, and examples thereof include one or more selected from the group consisting of a carbazole-based initiator, an oxime ester-based initiator, an aminoalkylphenone-based initiator and an acylphosphine oxide-based initiator. More specific examples of such photoinitiators include one or more selected from the group consisting of 2-octanedione-1 [(4-phenylthio)phenyl]-2-benzoyl-oxime, 1-[9-ethyl-6-(2-methylbenzoyl)-9H-carbazol-3-yl]ethanone-1-O-acetyloxime, (E)-2-(acetoxyimino)-1-(9,9-diethyl-9H-fluorene-2-yl)butanone and phenyl(4-methoxyphenyl)iodonium arsenic hexafluoride, and a variety of other photoinitiators can be used.

The photosensitive resin composition of the one embodiment mentioned above may comprise 45 to 100 parts by weight of the polyfunctional compound; 25 to 100 parts by weight of the pigment; and 2 to 30 parts by weight of the photoinitiator, based on 100 parts by weight of the alkali-soluble resin. If the content of each component is outside the above-mentioned range, the visibility of the display device may decrease, the light resistance, optical density, residual film characteristics, and adhesive force of the cured film may decrease, or the sensitivity, photoreactivity, light transmittance or the like of the composition may decrease.

Meanwhile, the composition of one embodiment may, in addition to the above-mentioned components, further include a crosslinking agent that further reacts with the alkali-soluble resin and/or polyfunctional compound in the exposed part to introduce an additional crosslinked structure into the cured film. Examples of such crosslinking agents may include a compound having one or more crosslinking groups selected from the group consisting of an alkoxy group having 1 to 10 carbon atoms such as a methoxy group or an ethoxy group, an alkoxyalkyl group having 1 to 15 carbon atoms such as an alkoxymethyl group or alkoxyethyl group, a hydroxy group, an epoxy group, and an oxetanyl group.

In a more specific example, the crosslinking agent may include one or more selected from the group consisting of the following Chemical Formulas 18 to 29. In addition, various compounds having the above-mentioned crosslinking group can be used without particular limitation:

[Chemical Formula 18]

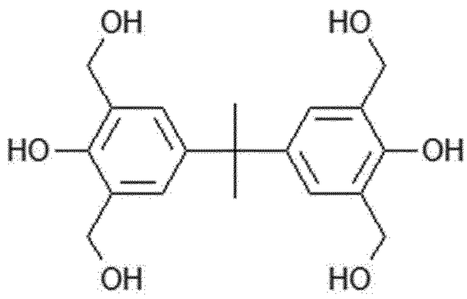

[Chemical Formula 19]

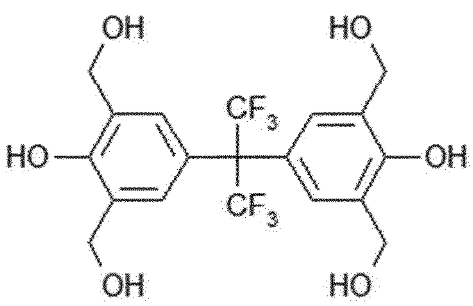

[Chemical Formula 20]

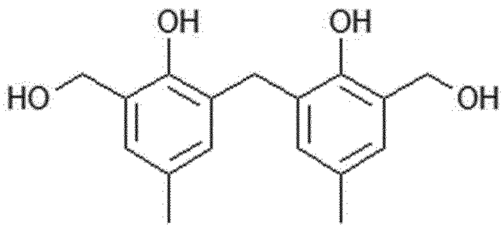

[Chemical Formula 21]

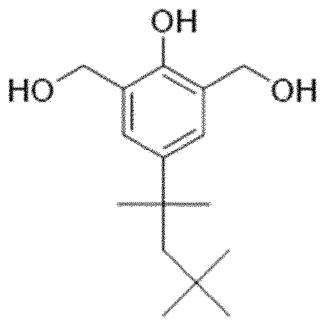

[Chemical Formula 22]

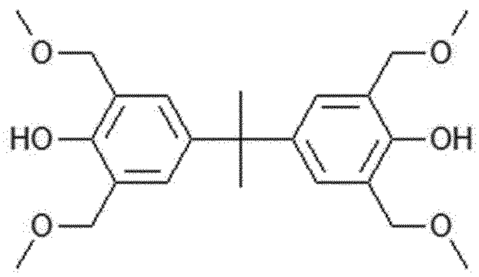

[Chemical Formula 23]

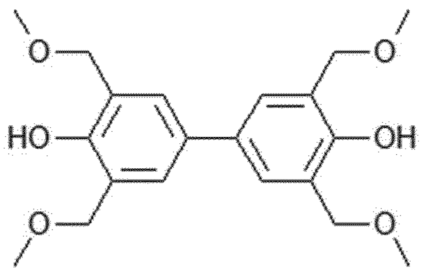

[Chemical Formula 24]

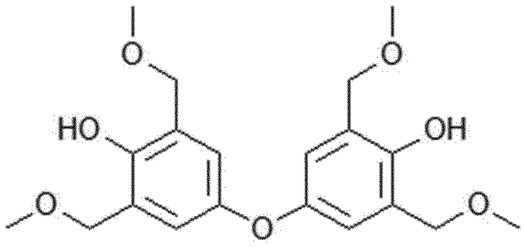

[Chemical Formula 25]

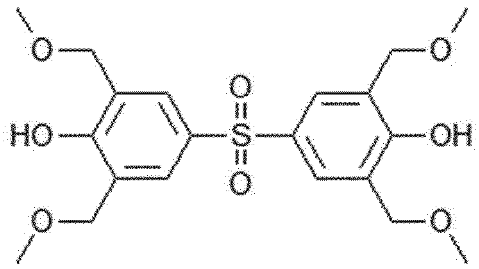

[Chemical Formula 26]

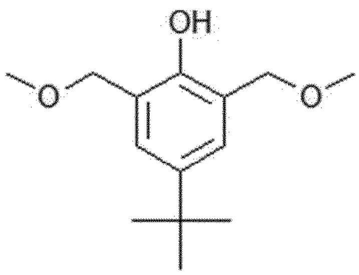

[Chemical Formula 27]

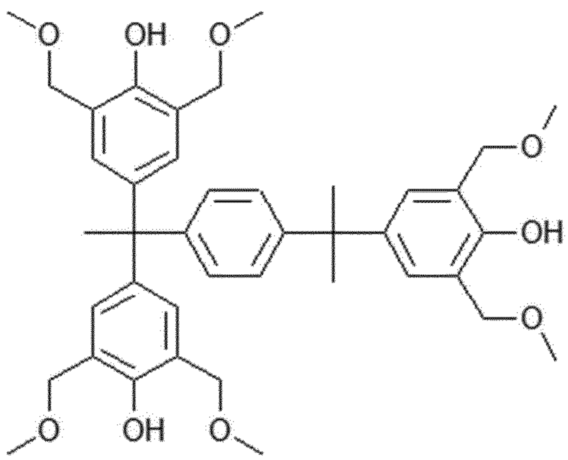

[Chemical Formula 28]

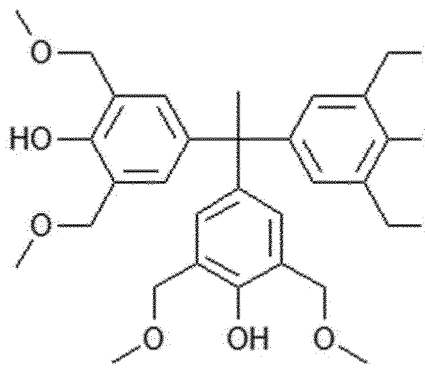

[Chemical Formula 29]

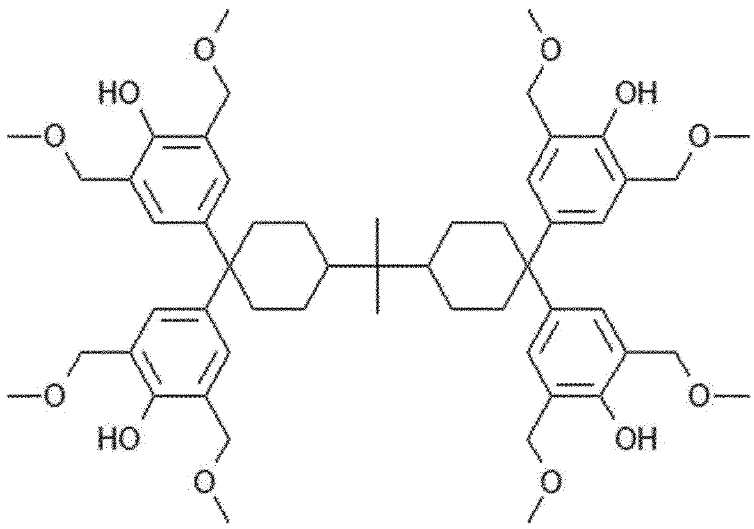

The above-mentioned crosslinking agent may be contained in an amount of 0.1 to 30 parts by weight based on 100 parts by weight of the alkali-soluble resin. If the content of the crosslinking agent is excessively high, there may be a problem that the adhesive force decreases due to an increase of developability in an unexposed part.

Meanwhile, the photosensitive resin composition of one embodiment may further include a solvent or an organic solvent for dispersing each of the above-mentioned components. Such an organic solvent may be included in an amount such that the solid content of the entire composition is 10 to 50% by weight, so as to easily perform processes such as solvent removal while uniformly the solvent or dispersing each of the above-mentioned components.

The type of such organic solvents is not particularly limited, and any solvent previously known to be usable in the photosensitive resin composition, for example, one or more organic solvents selected from the group consisting of an aromatic hydrocarbon-based solvent, an aliphatic hydrocarbon-based solvent, an ester-based solvent, an ether-based solvent, an alcohol-based solvent, an amide-based solvent and a ketone-based solvent may be used.

Meanwhile, the above-mentioned photosensitive resin composition is applied onto the target substrate, the part where the barrier rib or pixel defining layer pattern will remain is exposed through a photomask, and the composition of the exposed part is photocured. The composition of the remaining unexposed part is treated with an alkaline developer, for example, a 2.38 wt.% aqueous solution of tetramethylammonium hydroxide, and can be formed in the form of a cured film, more specifically, a barrier rib pattern having an inverted taper structure or a pixel defining layer pattern.

However, the specific progress conditions of such a pattern forming method depend on the pattern forming conditions of general photosensitive resin compositions and are also described in Examples described later, and thus, further description thereof will be omitted.

Meanwhile, according to another embodiment of the invention, a display device comprising a cured film/barrier

rib pattern formed from the composition of one embodiment as a pixel defining layer pattern is provided. Such a display device comprises a substrate; red, green and blue pixels defined on the substrate; and a pixel defining layer pattern that is formed between the pixels, and includes a cured film of the photosensitive resin composition according to the one embodiment.

As the display device of the other embodiment includes a cured film formed from the composition of one embodiment as a pixel defining layer pattern, it can have excellent visibility and contrast, and the pixel defining layer pattern can exhibit excellent light resistance, residual film characteristics, reliability, and adhesive force to the substrate.

For example, the cured film has an optical density (OD) defined by the following Mathematical Equation 1 of 0.5 to 3.0 , and thus can exhibit excellent light resistance:

[Mathematical Equation 1]

$$\text{Optical density (OD)}=2-\log T_{550}$$

wherein, in Mathematical Equation 1, $T_{550}$ represents the light transmittance (%) to 550nm light measured for a cured film having a thickness of 1$\mu$m.

In the display device of the other embodiment, the cured film comprises a polyfunctional compound contained in the composition of one embodiment, and a resin matrix in which the photocurable unsaturated functional groups contained in the alkali-soluble resin and the crosslinking group of the optionally contained crosslinking agent are cured to form a crosslinked structure. The cured film may also have a chemical structure that includes a pigment including a black pigment or a pigment mixture showing a black color dispersed in such a resin matrix, i.e., a cured and crosslinked alkali-soluble resin.

Meanwhile, the display device of the other embodiments mentioned above may be a variety of display devices such as an organic electroluminescent device (OLED device), and may have a general structure of each display device except for including a pixel defining layer pattern formed from the composition of one embodiment, and thus, a detailed description will be omitted.

Hereinafter, the preferred examples are provided for better understanding. However, these examples are for illustrative purposes only, and the invention is not intended to be limited by these examples.

**Preparation Example: Synthesis of alkali-soluble resin**

**Preparation Example 1: Synthesis of alkali-soluble resin of Chemical Formula 3A**

[Chemical Formula 3A]

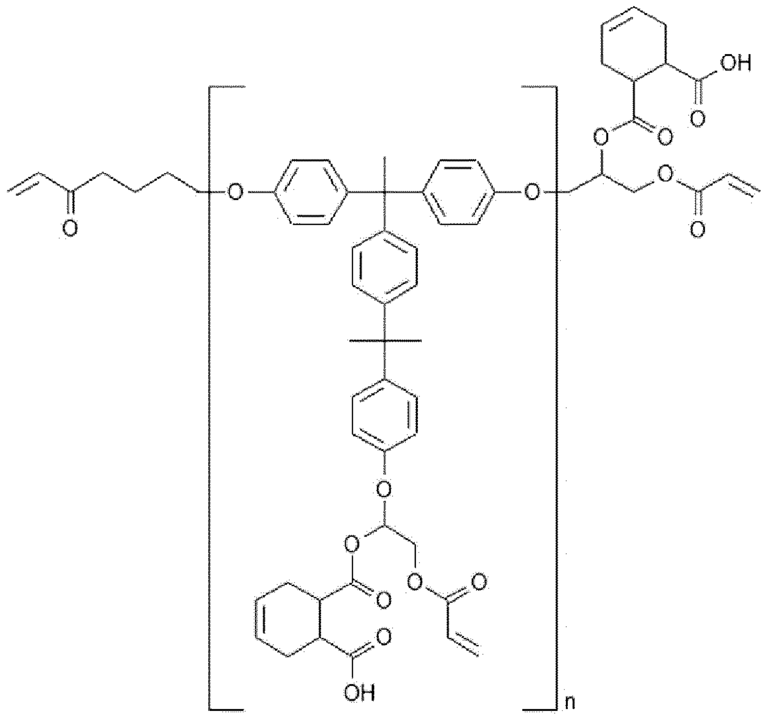

wherein, in Chemical Formula 3A, n is the number of repetitions and represents an integer from 2 to 100.

An alkali-soluble resin having a structure of Chemical Formula 3A was synthesized by the method described below.

First, 2.0 equivalents of epichlorohydrin was added to 4,4-[1-[4-[1-(1,4-hydroxyphenyl)-1-methylethyl]phenyl]ethylidene]bisphenol of Chemical Formula 3, and propylene glycol monomethyl ether monoacetate as a solvent was added in the presence of triethylamine so that the solid content was 80 wt.% of the reaction solution. The mixture was reacted at 100°C for 24 hours to obtain a reactive epoxy carboxylate compound solution. At this time, the degree of polymerization, number of repetitions n, and weight average molecular weight of the compound were adjusted by controlling the reaction time (Thereby, the weight average molecular weight of the alkali-soluble resin included in each example described later was adjusted).

Subsequently, 2-hydroxypropyl acrylate was added and reacted at 55°C for 24 hours to obtain an alkali-soluble resin in which the epoxy of the phenolic compound was acrylated. Finally, phthalic anhydride was added and reacted at 100°C for 24 hours to obtain the final alkali-soluble resin.

**Preparation Examples 2 to 15: Synthesis of alkali-soluble resins of Chemical Formulas 4A to 17A**

[Chemical Formula 4A]

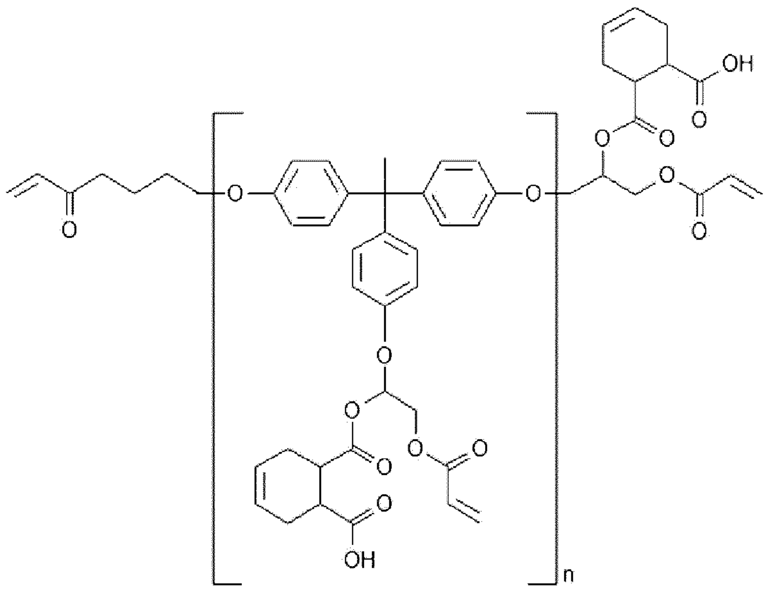

[Chemical Formula 5A]

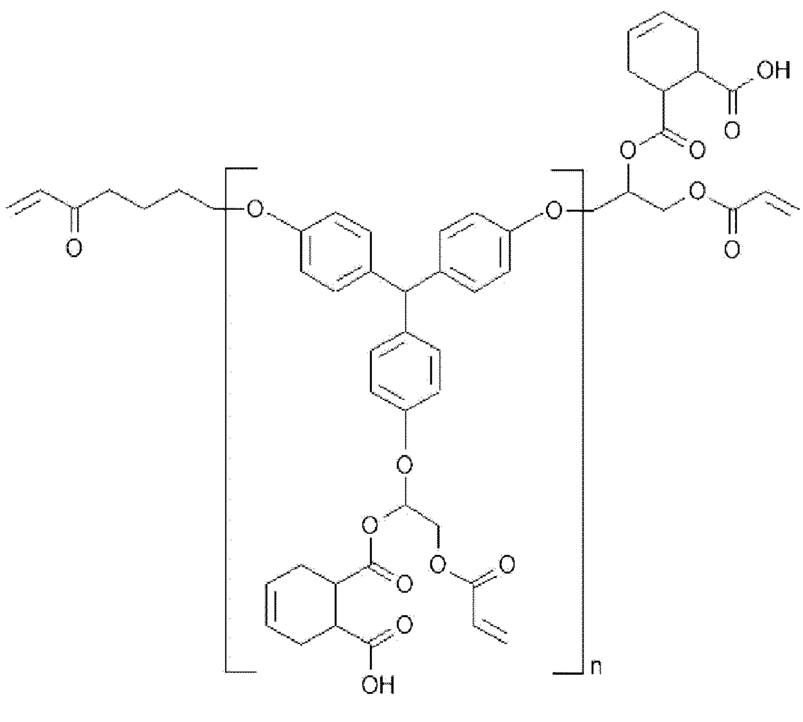

[Chemical Formula 6A]

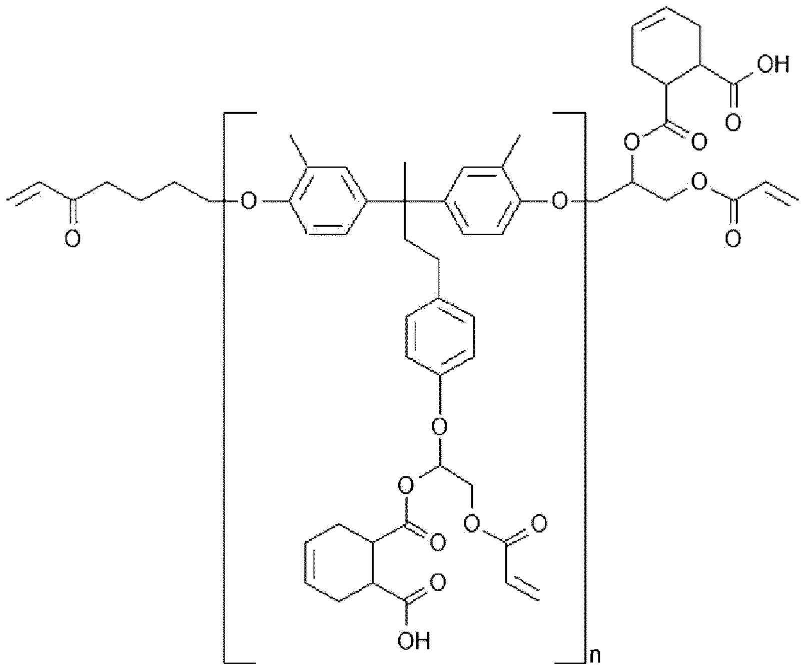

[Chemical Formula 7A]

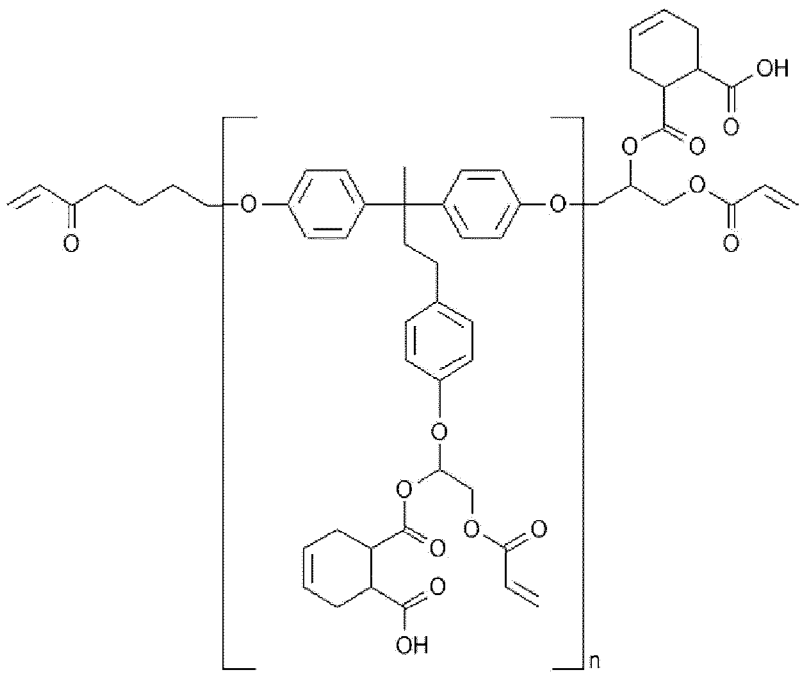

[Chemical Formula 8A]

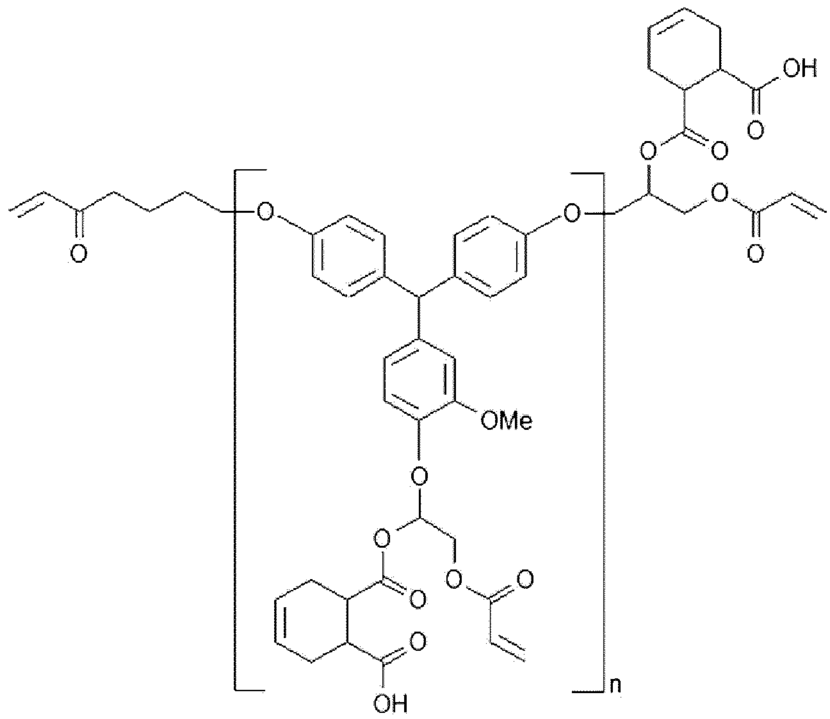

[Chemical Formula 9A]

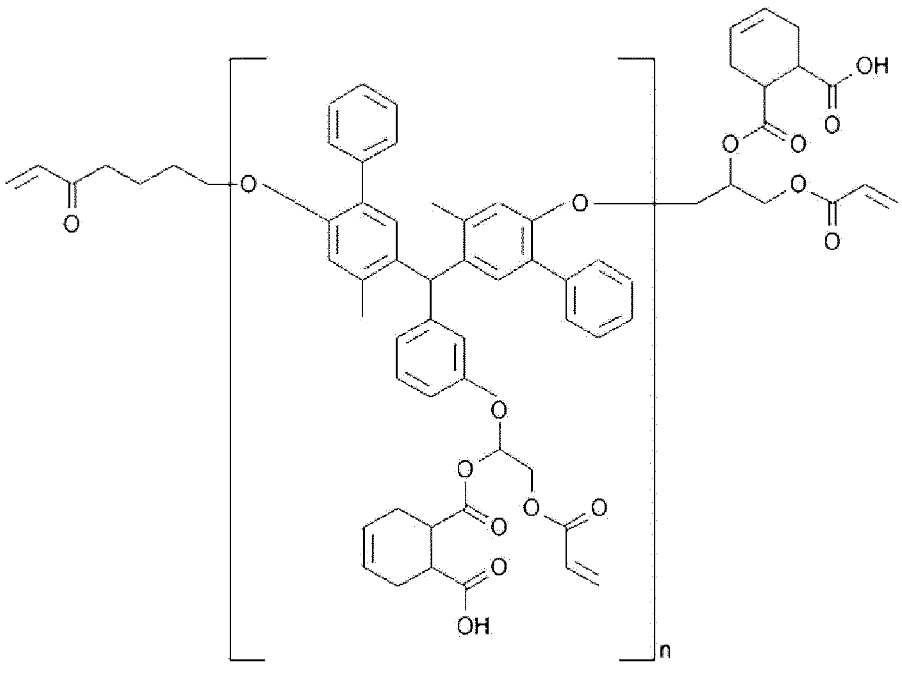

[Chemical Formula 10A]

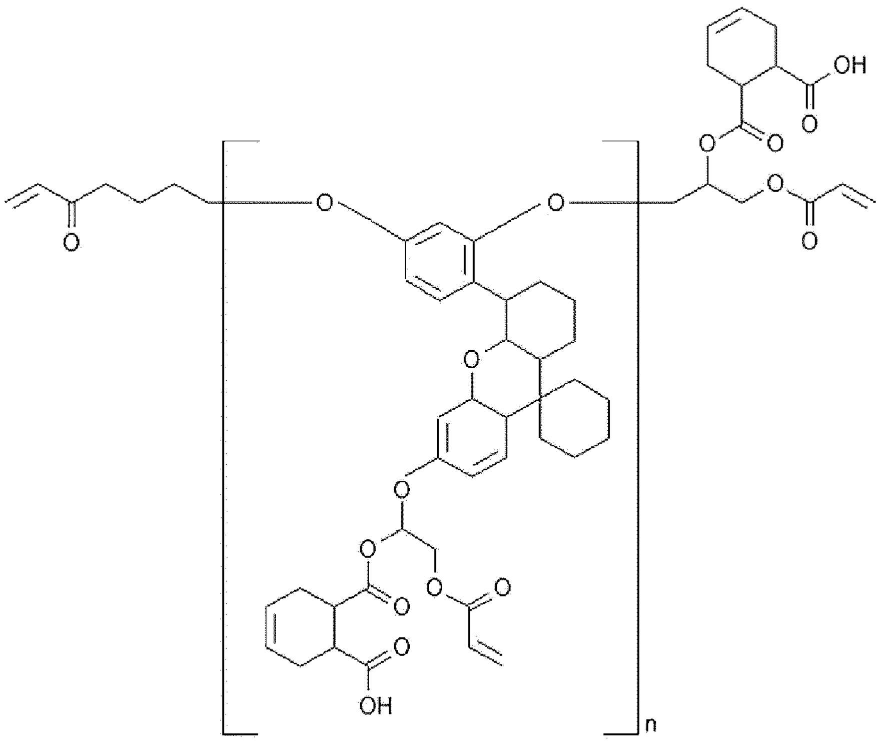

[Chemical Formula 11A]

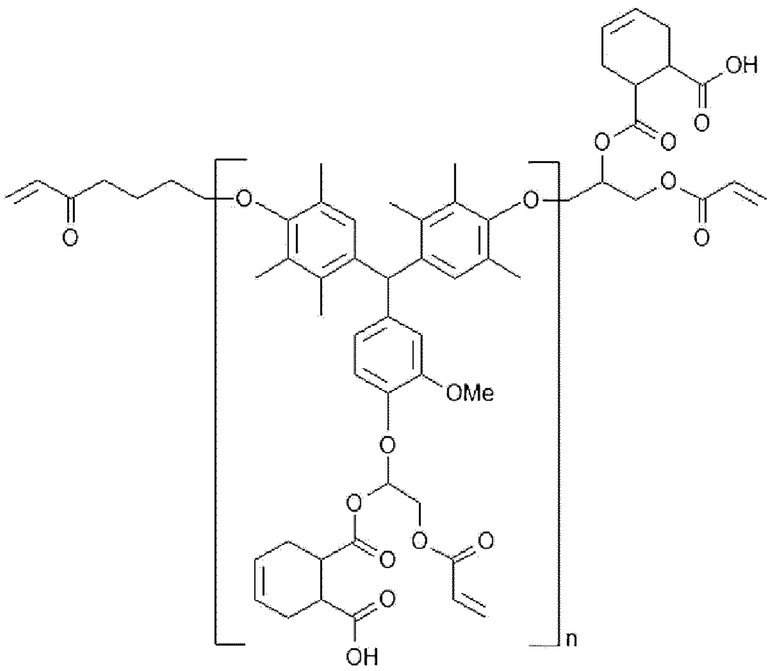

[Chemical Formula 12A]

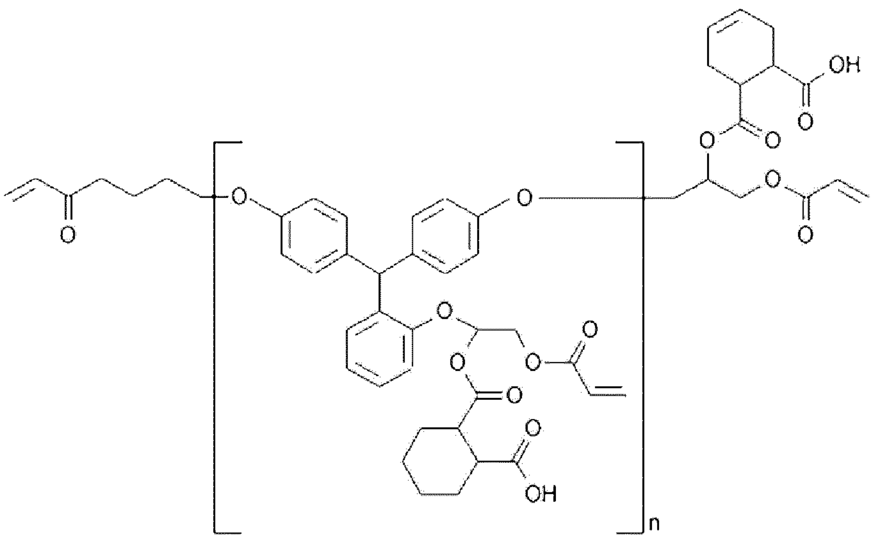

[Chemical Formula 13A]

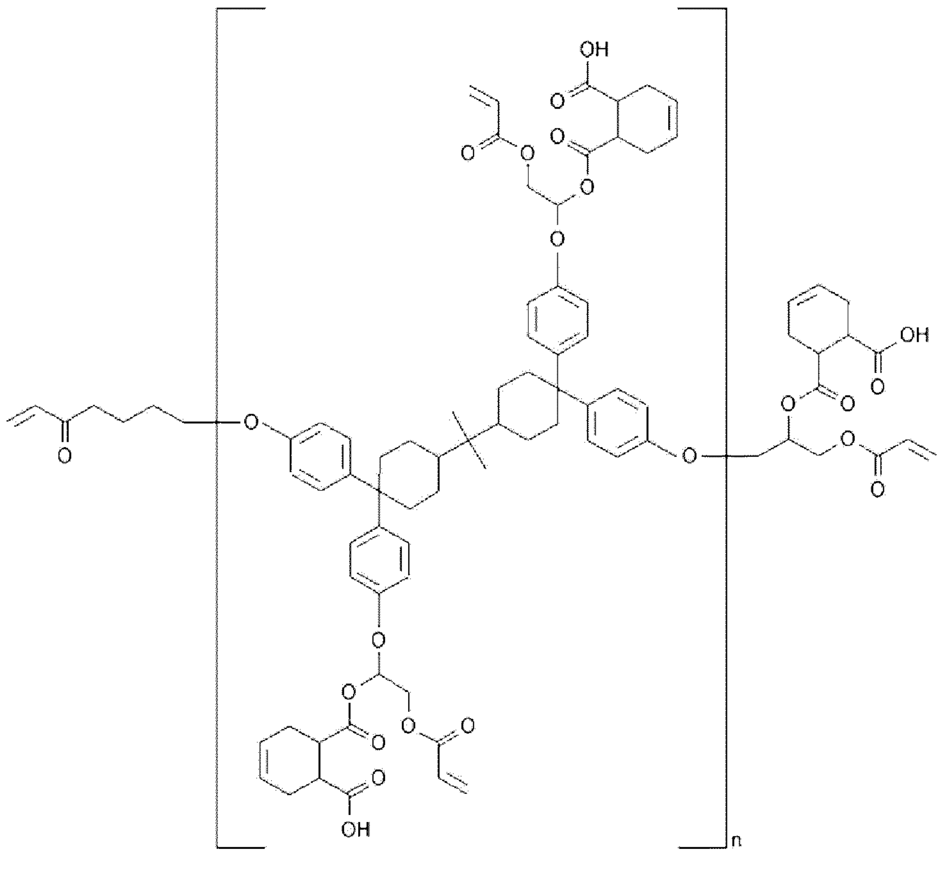

[Chemical Formula 14A]

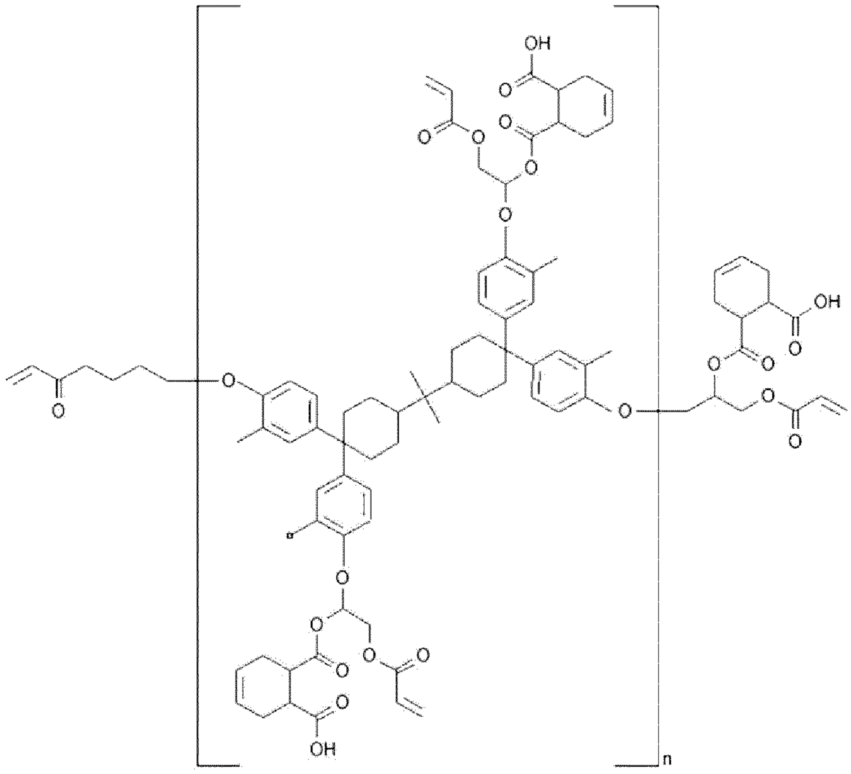

[Chemical Formula 15A]

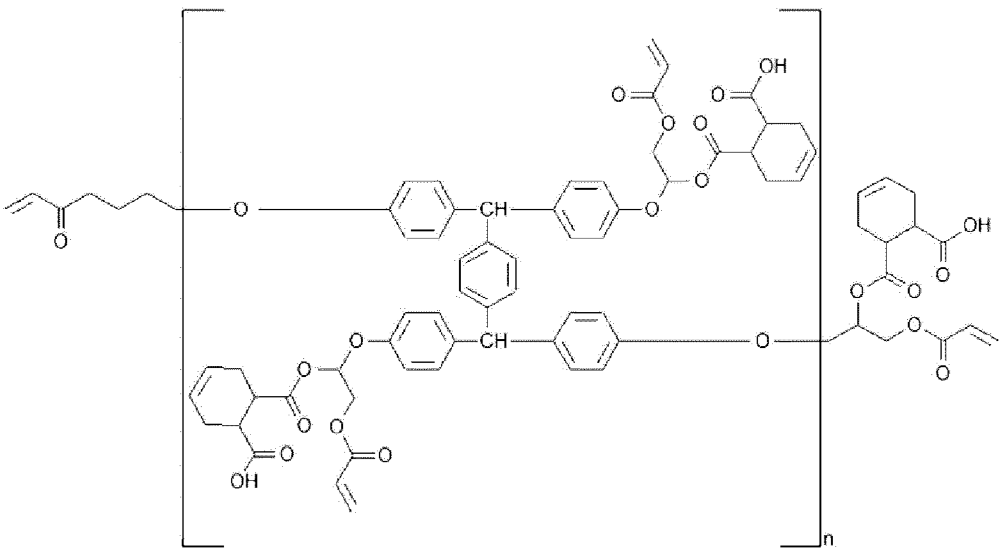

[Chemical Formula 16A]

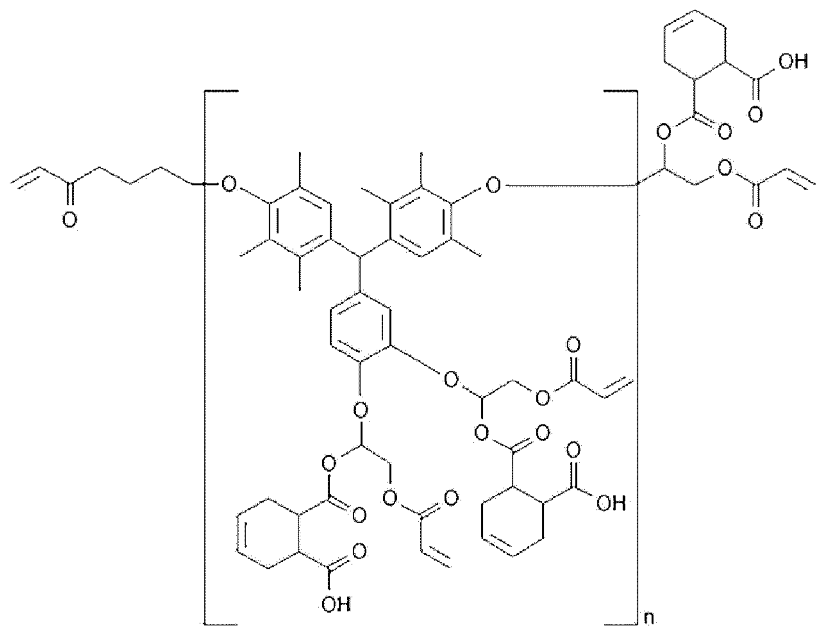

[Chemical Formula 17A]

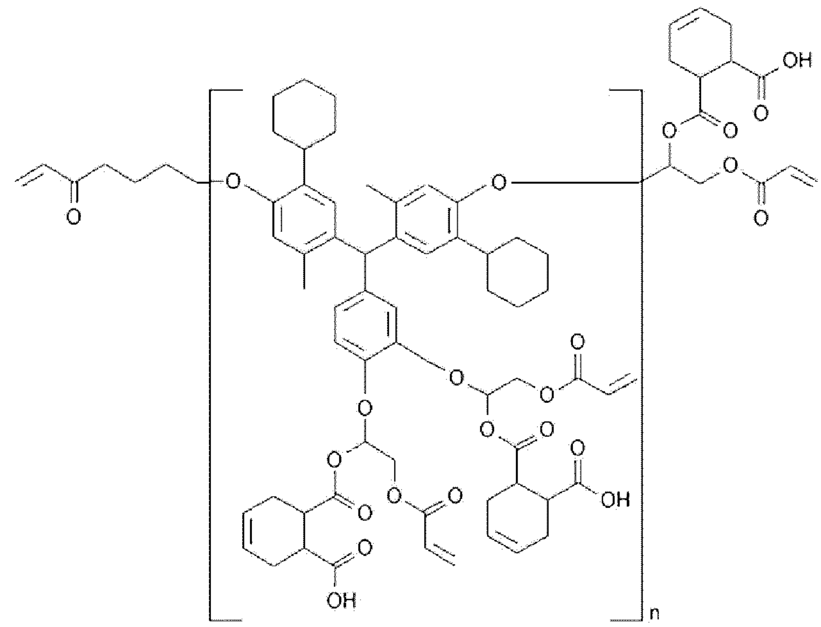

wherein, in Chemical Formula 4A to 17A, n is the number of repetitions and represents an integer of 2 to 100.

Alkali-soluble resins of Preparation Examples 2 to 15 represented by Chemical Formulas 4A to 17A were respectively obtained in the same manner as in Preparation Example 1, except that as the phenolic compound in Preparation Example 1, the compounds selected from Chemical Formulas 4 to 17 are used instead of the compound of Chemical Formula 3.

In Preparation Examples 2 to 15, the degree of polymerization, number of repetitions n, and weight average molecular weight of the alkali-soluble resin were also adjusted by controlling the reaction time of the first reaction step (Thereby, the weight average molecular weight of the alkali-soluble resin included in each Example described later was adjusted).

**Comparative Preparation Examples 1 and 2: Synthesis of alkali-soluble resins of Chemical Formulas 30 and 31**

[Chemical Formula 30]

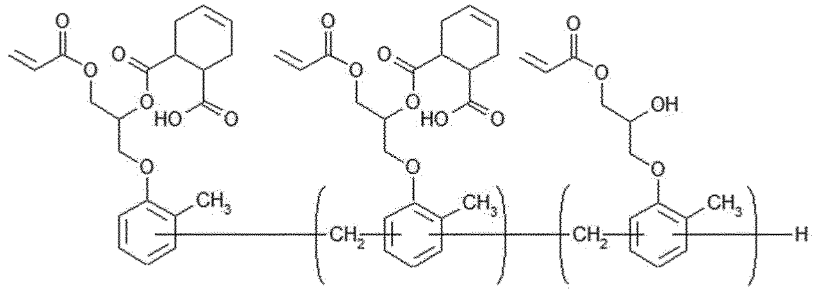

[Chemical Formula 31]

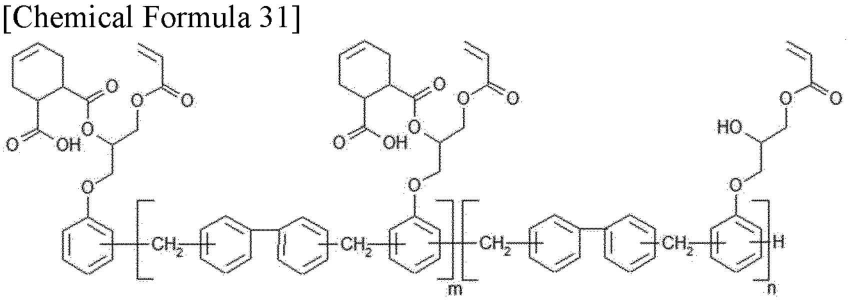

wherein, in Chemical Formulas 30 and 31, n is the number of repetitions and represents an integer of 2 to 100.

Alkali-soluble resins of Comparative Preparation Examples 1 and 2 represented by Chemical Formula 30 or 31 were respectively obtained in the same manner as in Preparation Example 1, except that as the phenol-based compound in Preparation Example 1, a cresol novolac compound or a biphenyl-containing compound was used instead of the compound of Chemical Formula 3 .

In Comparative Preparation Examples 1 and 2, the degree of polymerization, number of repetitions n, and weight average molecular weight of the alkali-soluble resin were also adjusted by controlling the reaction time of the first reaction step (thereby, the weight average molecular weight of the alkali-soluble resin included in each Comparative Example described later was adjusted).

**Examples 1 to 30 and Comparative Examples 1 to 4: Preparation of photosensitive resin composition and formation of cured film**

In accordance with the compositions summarized in Tables 1 to 3 below, the alkali-soluble resin, polyfunctional compound, pigment, photoinitiator, crosslinking agent, and organic solvent of polyethylene glycol methyl ether acetate (PGMEA) were uniformly mixed while stirring so to have a solid content of about 20 wt.%. Thereby, photosensitive resin compositions of Examples and Comparative Examples were prepared. At this time, the composition of the black pigment represented by each pigment number was the same as summarized in Table 1, the composition of the polyfunctional compound and photoinitiator used in each of the Examples and Comparative Examples were the same as summarized in Table 2, and the composition of the entire photosensitive resin composition was the same as summarized in Table 3.

The photosensitive resin composition was spin-coated onto an ITO substrate and then prebaked in an oven at a temperature of 100 to 120°C for 2 minutes to form a cured film. At this time, the cured film was formed to have a thickness of about 1$\mu$m.

[Table 1]

| Composition of pigment | | | | | |
|---|---|---|---|---|---|
| | Black S 0100 CF | C. I. Pigment Red 254 | C. I. Pigment Blue 15:6 | C. I. Pigment Violet 29 | Carbon Block |
| Pigment 1 | 100 | | | | |
| Pigment 2 | | 45 | 40 | 15 | |
| Pigment 3 | | | | | 100 |
| Pigment 4 | 90 | 10 | | | |

(continued)

| Composition of pigment | | | | | |
|---|---|---|---|---|---|
| | Black S 0100 CF | C. I. Pigment Red 254 | C. I. Pigment Blue 15:6 | C. I. Pigment Violet 29 | Carbon Block |
| Pigment 5 | 90 | | 10 | | |
| Pigment 6 | 90 | | | 10 | |
| * The content of each pigment is represented by parts by weight, based on 100 parts by weight of the total pigment.<br>* Pigment 2 is a mixture of red, blue and violet pigments, exhibiting a black color as a whole. | | | | | |

[Table 2]

| | Composition of photoinitiator and polyfunctional compound | | | | | | | | | |
|---|---|---|---|---|---|---|---|---|---|---|
| | Photoinitiator (pts. wt.) | | | | Polyfunctional compound (pts. wt.) | | | | | |
| | Photoi nitiator 1 | Photoi nitiator 2 | Photoi nitiator 3 | Photoi nitiator 4 | DPHA | DPPA | DTTA | TPTA | TCDA | 1,6-Hexanediol diacrylate |
| Example 1 | 0.0 | 7.5 | 7.5 | 7.5 | 0.0 | 30.0 | 15.0 | 0.0 | 30.0 | 15.0 |
| Example 2 | 0.0 | 0.0 | 7.5 | 7.5 | 0.0 | 30.0 | 15.0 | 5.0 | 30.0 | 20.0 |
| Example 3 | 0.0 | 0.0 | 0.0 | 7.5 | 5.0 | 25.0 | 10.0 | 5.0 | 25.0 | 20.0 |
| Example 4 | 2.5 | 0.0 | 0.0 | 0.0 | 5.0 | 25.0 | 10.0 | 10.0 | 25.0 | 5.0 |
| Example 5 | 2.5 | 2.5 | 0.0 | 0.0 | 10.0 | 20.0 | 5.0 | 10.0 | 20.0 | 5.0 |
| Example 6 | 2.5 | 2.5 | 2.5 | 0.0 | 10.0 | 20.0 | 5.0 | 15.0 | 20.0 | 10.0 |
| Example 7 | 5.0 | 2.5 | 2.5 | 2.5 | 15.0 | 15.0 | 0.0 | 15.0 | 15.0 | 10.0 |
| Example 8 | 5.0 | 5.0 | 2.5 | 2.5 | 15.0 | 15.0 | 0.0 | 20.0 | 15.0 | 15.0 |
| Example 9 | 5.0 | 5.0 | 5.0 | 2.5 | 20.0 | 10.0 | 15.0 | 20.0 | 10.0 | 15.0 |
| Example 10 | 7.5 | 5.0 | 5.0 | 5.0 | 20.0 | 10.0 | 15.0 | 25.0 | 10.0 | 20.0 |
| Example 11 | 7.5 | 7.5 | 5.0 | 5.0 | 25.0 | 5.0 | 10.0 | 25.0 | 5.0 | 20.0 |
| Example 12 | 7.5 | 7.5 | 7.5 | 5.0 | 25.0 | 5.0 | 10.0 | 30.0 | 5.0 | 5.0 |
| Example 13 | 0.0 | 7.5 | 7.5 | 7.5 | 30.0 | 0.0 | 5.0 | 30.0 | 0.0 | 5.0 |
| Example 14 | 0.0 | 0.0 | 7.5 | 7.5 | 30.0 | 0.0 | 5.0 | 0.0 | 0.0 | 10.0 |
| Example 15 | 0.0 | 0.0 | 0.0 | 7.5 | 0.0 | 30.0 | 0.0 | 0.0 | 30.0 | 10.0 |
| Example 16 | 2.5 | 0.0 | 0.0 | 0.0 | 0.0 | 30.0 | 0.0 | 5.0 | 30.0 | 15.0 |
| Example 17 | 2.5 | 2.5 | 0.0 | 0.0 | 5.0 | 25.0 | 15.0 | 5.0 | 25.0 | 15.0 |
| Example 18 | 2.5 | 2.5 | 2.5 | 0.0 | 5.0 | 25.0 | 15.0 | 10.0 | 25.0 | 20.0 |
| Example 19 | 5.0 | 2.5 | 2.5 | 2.5 | 10.0 | 20.0 | 10.0 | 10.0 | 20.0 | 20.0 |
| Example 20 | 5.0 | 5.0 | 2.5 | 2.5 | 10.0 | 20.0 | 10.0 | 15.0 | 20.0 | 5.0 |
| Example 21 | 5.0 | 5.0 | 5.0 | 2.5 | 15.0 | 15.0 | 5.0 | 15.0 | 15.0 | 5.0 |
| Example 22 | 7.5 | 5.0 | 5.0 | 5.0 | 15.0 | 15.0 | 5.0 | 20.0 | 15.0 | 10.0 |
| Example 23 | 7.5 | 7.5 | 5.0 | 5.0 | 20.0 | 10.0 | 0.0 | 20.0 | 10.0 | 10.0 |

(continued)

| Composition of photoinitiator and polyfunctional compound | | | | | | | | | | |
|---|---|---|---|---|---|---|---|---|---|---|
| | Photoinitiator (pts. wt.) | | | | Polyfunctional compound (pts. wt.) | | | | | |
| | Photoi nitiator 1 | Photoi nitiator 2 | Photoi nitiator 3 | Photoi nitiator 4 | DPHA | DPPA | DTTA | TPTA | TCDA | 1,6-Hexanediol diacrylate |
| Example 24 | 7.5 | 7.5 | 7.5 | 5.0 | 20.0 | 10.0 | 0.0 | 25.0 | 10.0 | 15.0 |
| Example 25 | 0.0 | 7.5 | 7.5 | 7.5 | 25.0 | 5.0 | 15.0 | 25.0 | 5.0 | 15.0 |
| Example 26 | 0.0 | 0.0 | 7.5 | 7.5 | 25.0 | 5.0 | 15.0 | 30.0 | 5.0 | 20.0 |
| Example 27 | 0.0 | 0.0 | 0.0 | 7.5 | 30.0 | 0.0 | 10.0 | 30.0 | 0.0 | 20.0 |
| Example 28 | 2.5 | 0.0 | 0.0 | 0.0 | 30.0 | 0.0 | 10.0 | 0.0 | 0.0 | 5.0 |
| Example 29 | 2.5 | 2.5 | 0.0 | 0.0 | 0.0 | 30.0 | 5.0 | 0.0 | 30.0 | 5.0 |
| Example 30 | 2.5 | 2.5 | 2.5 | 0.0 | 0.0 | 30.0 | 5.0 | 5.0 | 30.0 | 10.0 |
| Comparati ve Example 1 | 0.0 | 0.0 | 0.0 | 7.5 | 5.0 | 25.0 | 10.0 | 5.0 | 25.0 | 20.0 |
| Comparati ve Example 2 | 2.5 | 0.0 | 0.0 | 0.0 | 5.0 | 25.0 | 10.0 | 10.0 | 25.0 | 5.0 |
| Comparati ve Example 3 | 2.5 | 2.5 | 0.0 | 0.0 | 10.0 | 20.0 | 5.0 | 10.0 | 20.0 | 5.0 |
| Comparati ve Example 4 | 2.5 | 2.5 | 2.5 | 0.0 | 10.0 | 20.0 | 5.0 | 15.0 | 20.0 | 10.0 |

* In the photosensitive resin composition of each of Examples and Comparative Examples, the relative content of each photoinitiator and crosslinking agent contained in 100 parts by weight of the alkali-soluble resin is represented by parts by weight.

*Name of 1 photoinitiator compound:

1. Initiator 1: 1,2-octanedione-1[(4-phenylthio)phenyl]-2-benzoyl-oxime;
2. Initiator 2: 1-[9-ethyl-6-(2-methylbenzoyl)-9H-carbazol-3-yl]ethanone-1-O-acetyloxime;
3. Initiator 3: (E)-2-(acetoxyimino)-1-(9,9-diethyl-9H-fluoren-2-yl)butanone;
4. Initiator 4: Phenyl(4-methoxyphenyl) iodonium arsenic hexafluoride

* Neme of crosslinking agent compound:

1. DPHA: dipentaerythritol hexaacrylate;
2. DPPA: dipentaerythritol pentaacrylate;
3. DTTA: ditrimethylolpropane tetraacrylate;
4. TPTA: trimethylolpropane triacrylate;
5. TCDA: Tricyclodecane dimethanol diacrylate.

[Table 3]

| Composition of photosensitive resin composition | | | | | |
|---|---|---|---|---|---|
| | Alkali-soluble resin 100 pts. wt. (Chemical Formula, Mw) | Polyfunctional compound (total pts. wt.) | Black Pigment (Pigment No., particle size, pts. wt.) | Photoinitiator (total pts. wt.) | Crosslinking agent (Chemical Formula, pts. wt.) |
| Example 1 | Chemical Formula 3A(Mw: 2000) | 90.0 | Pigment 1 (particle size: 100nm, 30 pts. wt.) | 22.5 | Not included |
| Example 2 | Chemical Formula 4A(Mw: 4000) | 100.0 | Pigment 2 (particle size: 150nm, 40 pts. wt.) | 15.0 | Not included |
| Example 3 | Chemical Formula 5A(Mw: 6000) | 90.0 | Pigment 3 (particle size: 200nm, 50 pts. wt.) | 7.5 | Not included |
| Example 4 | Chemical Formula 6A(Mw: 8000) | 80.0 | Pigment 4 (particle size: 100nm, 60 pts. wt.) | 2.5 | Not included |
| Example 5 | Chemical Formula 7A(Mw: 10000) | 70.0 | Pigment 5 (particle size: 150nm, 70 pts. wt.) | 5.0 | Not included |
| Example 6 | Chemical Formula 8A(Mw: 12000) | 80.0 | Pigment 6 (particle size: 200nm, 80 pts. wt.) | 7.5 | Not included |
| Example 7 | Chemical Formula 9A(Mw: 14000) | 70.0 | Pigment 1 (particle size: 100nm, 90 pts. wt.) | 12.5 | Not included |
| Example 8 | Chemical Formula 10A (Mw: 16000) | 80.0 | Pigment 2 (particle size: 150nm, 100 pts. wt.) | 15.0 | Not included |
| Example 9 | Chemical Formula 11A (Mw: 20000) | 90.0 | Pigment 3 (particle size: 200nm, 30 pts. wt.) | 17.5 | Not included |
| Example 10 | Chemical Formula 12A (Mw: 22000) | 100.0 | Pigment 4 (particle size: 100nm, 40 pts. wt.) | 22.5 | Not included |
| Example 11 | Chemical Formula 13A (Mw: 24000) | 90.0 | Pigment 5 (particle size: 150nm, 50 pts. wt.) | 25.0 | Not included |

(continued)

| Composition of photosensitive resin composition | | | | | |
|---|---|---|---|---|---|
| | Alkali-soluble resin 100 pts. wt. (Chemical Formula, Mw) | Polyfunctional compound (total pts. wt.) | Black Pigment (Pigment No., particle size, pts. wt.) | Photoinitiator (total pts. wt.) | Crosslinking agent (Chemical Formula, pts. wt.) |
| Example 12 | Chemical Formula 14A (Mw: 26000) | 80.0 | Pigment 6 (particle size: 200nm, 60 pts. wt.) | 27.5 | Not included |
| Example 13 | Chemical Formula 15A (Mw: 28000) | 70.0 | Pigment 1 (particle size: 100nm, 70 pts. wt.) | 22.5 | Not included |
| Example 14 | Chemical Formula 16A (Mw: 30000) | 45.0 | Pigment 2 (particle size: 150nm, 80 pts. wt.) | 15.0 | Not included |
| Example 15 | Chemical Formula 17A (Mw: 2000) | 70.0 | Pigment 3 (particle size: 200nm, 90 pts. wt.) | 7.5 | Not included |
| Example 16 | Chemical Formula 3A (Mw: 2000) | 80.0 | Pigment 4 (particle size: 100nm, 100 pts. wt.) | 2.5 | Chemical Formula 18 (5 pts. wt.) |
| Example 17 | Chemical Formula 4A (Mw: 4000) | 90.0 | Pigment 5 (particle size: 150nm, 30 pts. wt.) | 5.0 | Chemical Formula 19 (10 pts. wt.) |
| Example 18 | Chemical Formula 5A (Mw: 6000) | 100.0 | Pigment 6 (particle size: 200nm, 40 pts. wt.) | 7.5 | Chemical Formula 20 (15 pts. wt.) |
| Example 19 | Chemical Formula 6A (Mw: 8000) | 90.0 | Pigment 1 (particle size: 100nm, 50 pts. wt.) | 12.5 | Chemical Formula 21 (20 pts. wt.) |
| Example 20 | Chemical Formula 7A (Mw: 10000) | 80.0 | Pigment 2 (particle size: 150nm, 60 pts. wt.) | 15.0 | Chemical Formula 22 (5 pts. wt.) |
| Example 21 | Chemical Formula 8A (Mw: 12000) | 70.0 | Pigment 3 (particle size: 200nm, 70 pts. wt.) | 17.5 | Chemical Formula 23 (10 pts. wt.) |
| Example 22 | Chemical Formula 9A (Mw: 14000) | 80.0 | Pigment 4 (particle size: 100nm, 80 pts. wt.) | 22.5 | Chemical Formula 24 (15 pts. wt.) |

(continued)

| Composition of photosensitive resin composition | | | | | |
|---|---|---|---|---|---|
| | Alkali-soluble resin 100 pts. wt. (Chemical Formula, Mw) | Polyfunctional compound (total pts. wt.) | Black Pigment (Pigment No., particle size, pts. wt.) | Photoinitiator (total pts. wt.) | Crosslinking agent (Chemical Formula, pts. wt.) |
| Example 23 | Chemical Formula 10A (Mw: 16000) | 70.0 | Pigment 5 (particle size: 150nm, 90 pts. wt.) | 25.0 | Chemical Formula 25 (20 pts. wt.) |
| Example 24 | Chemical Formula 11A (Mw: 20000) | 80.0 | Pigment 6 (particle size: 200nm, 100 pts. wt.) | 27.5 | Chemical Formula 26 (5 pts. wt.) |
| Example 25 | Chemical Formula 12A (Mw: 22000) | 90.0 | Pigment 1 (particle size: 100nm, 30 pts. wt.) | 22.5 | Chemical Formula 27 (10 pts. wt.) |
| Example 26 | Chemical Formula 13A (Mw: 24000) | 100.0 | Pigment 2 (particle size: 150nm, 40 pts. wt.) | 15.0 | Chemical Formula 28 (15 pts. wt.) |
| Example 27 | Chemical Formula 14A (Mw: 26000) | 90.0 | Pigment 3 (particle size: 200nm, 50 pts. wt.) | 7.5 | Chemical Formula 29 (20 pts. wt.) |
| Example 28 | Chemical Formula 15A (Mw: 28000) | 45.0 | Pigment 4 (particle size: 100nm, 60 pts. wt.) | 2.5 | Chemical Formula 18 (5 pts. wt.) |
| Example 29 | Chemical Formula 16A (Mw: 30000) | 70.0 | Pigment 5 (particle size: 150nm, 70 pts. wt.) | 5.0 | Chemical Formula 19 (10 pts. wt.) |
| Example 30 | Chemical Formula 17A (Mw: 2000) | 80.0 | Pigment 6 (particle size: 200nm, 80 pts. wt.) | 7.5 | Chemical Formula 20 (15 pts. wt.) |
| Comparative Example 1 | Chemical Formula 30 (Mw: 6500) | 90.0 | Pigment 3 (particle size: 200nm, 50 pts. wt.) | 7.5 | Chemical Formula 19 (5 pts. wt.) |
| Comparative Example 2 | Chemical Formula 30 (Mw: 5700) | 80.0 | Pigment 4 (particle size: 100nm, 60 pts. wt.) | 2.5 | Chemical Formula 20 (10 pts. wt.) |
| Comparative Example 3 | Chemical Formula 31 (Mw: 6000) | 70.0 | Pigment 5 (particle size: 150nm, 70 pts. wt.) | 5.0 | Chemical Formula 21 (15 pts. wt.) |

(continued)

| Composition of photosensitive resin composition | | | | | |
|---|---|---|---|---|---|
| | Alkali-soluble resin 100 pts. wt. (Chemical Formula, Mw) | Polyfunctional compound (total pts. wt.) | Black Pigment (Pigment No., particle size, pts. wt.) | Photoinitiator (total pts. wt.) | Crosslinking agent (Chemical Formula, pts. wt.) |
| Comparative Example 4 | Chemical Formula 31 (Mw: 3000) | 80.0 | Pigment 6 (particle size: 200nm, 80 pts. wt.) | 7.5 | Chemical Formula 22 (20 pts. wt.) |
| * In the photosensitive resin composition of each of Examples and Comparative Examples, the relative total content of each remaining component contained in 100 parts by weight of the alkali-soluble resin is represented by parts by weight. | | | | | |

**Test Example: Preparation of alkali-soluble resin and photosensitive resin composition and evaluation of physical properties of cured film pattern**

1. Measurement of Mw of alkali soluble resin:

The weight average molecular weight of each alkali-soluble resin prepared in Preparation Examples and Comparative Preparation Examples was measured through GPC analysis.

More specifically, the GPC analysis was performed using KF-803, KF-802 and KF-801 columns as Waters 2695 and PDA 996 equipment, and measurement was performed using polystyrene as a standard material in the column, and using tetrahydrofuran as a mobile phase under the condition of a flow rate of 1ml/min. The Mw of each alkali-soluble resin measured in this way is summarized in Table 3 above.

2. Sensitivity evaluation:

The cured films formed in Examples and Comparative Examples were irradiated with ultraviolet rays having an intensity of 20 $mW/cm^2$ at 365 to 435 nm for 1 to 20 seconds at 1 second intervals using a predetermined pattern mask. Next, the films were developed with a 2.38 wt.% aqueous solution of tetramethylammonium hydroxide at 23°C for 1 minute, and then washed with ultrapure water for 1 minute.

For final curing, heating was performed at 260°C for 60 minutes in an oven to obtain a cured film pattern. Using SEM, the exposure amount at which the residual film rate was saturated was measured using sensitivity based on a 20 $\mu$m Line & Space CD standard.

Based on the exposure amount at which the residual film rate was saturated, each film was evaluated as 100 mJ or less: ◎, 100 ~ 200 mJ: ◦, and 200 mJ or more: X, and the results are summarized in Table 4 below.

3. Evaluation of optical density (OD):

In the cured film pattern forming process which is the same in the sensitivity evaluation, the remaining steps were performed similarly without intervening the pattern mask to produce a cured film with a thickness of 1.0 $\mu$m after final curing, and then the transmittance of this cured film at 550 nm was measured using an optical density meter (361T, Xlite) to determine the optical density for a thickness of 1 $\mu$m.

This optical density was calculated from the light transmittance according to the following Mathematical Equation 1:

[Mathematical Equation 1]

$$\text{Optical density (OD)} = 2 - \log T_{550}$$

wherein, in Mathematical Equation 1, $T_{550}$ represents the light transmittance (%) to 550nm light measured for a cured film having a thickness of 1$\mu$m.

The corresponding OD evaluation results are summarized and shown in Table 4 below.

4. Residue evaluation:

A cured film was formed in the same manner as in the sensitivity evaluation, and then the residue of this cured film were measured at a 20 μm Contact Hole using an optical microscope (OLS-4100, Olympus), It was evaluated as ○ if no residues existed, and as X if residues existed, respectively, and the results are summarized and shown in Table 4 below.

5. Evaluation of adhesive force:

A cured film was formed in the same manner as in the sensitivity evaluation, and then the adhesive force of this cured film was measured at a 20 μm Contact Hole using an optical microscope (OLS-4100, Olympus). It was evaluated as ○ if there was no abnormality in adhesive force, and as X if peel-off occurred, respectively, and the results are summarized and shown in Table 4 below.

6. Evaluation of straightness:

A cured film was formed in the same manner as in the sensitivity evaluation, the straightness of this cured film was measured at a 20 μm Contact Hole using an optical microscope (OLS-4100, Olympus). It was evaluated as ○ if straightness was excellent, and as X if straightness was inferior, respectively, and the results are summarized and shown in Table 4 below.

7. Reliability evaluation:

A cured film was formed in the same manner as in the evaluation of sensitivity, and a cured film pattern was formed on an ITO substrate patterned in the form shown in FIG. 1, and EL was deposited. Al was deposited on the upper part using a cathode electrode, and the encapsulation step was performed. Based on 85°C and 85% RH, the time (T97) during which luminance was dropped by 3% with the device turned on was evaluated. It was evaluated as ○ if 1000 hours or more were secured, and as X if less than 1000 hours was secured, respectively, and the evaluation results are summarized and shown in Table 4 below.

Table 4

| | Sensitivity | Optical density (OD) | Residue | Adhesive force | Straightness | Reliability |
|---|---|---|---|---|---|---|
| Example 1 | ◎ | 1.0 | ○ | ○ | ○ | ○ |
| Example 2 | ◎ | 0.7 | ○ | ○ | ○ | ○ |
| Example 3 | ○ | 1.9 | ○ | ○ | ○ | ○ |
| Example 4 | ○ | 1.9 | ○ | ○ | ○ | ○ |
| Example 5 | ○ | 2.2 | ○ | ○ | ○ | ○ |
| Example 6 | ○ | 2.4 | ○ | ○ | ○ | ○ |
| Example 7 | ○ | 2.8 | ○ | ○ | ○ | ○ |
| Example 8 | ○ | 1.9 | ○ | ○ | ○ | ○ |
| Example 9 | ◎ | 1.3 | ○ | ○ | ○ | ○ |
| Example 10 | ◎ | 1.2 | ○ | ○ | ○ | ○ |
| Example 11 | ◎ | 1.5 | ○ | ○ | ○ | ○ |
| Example 12 | ◎ | 1.9 | ○ | ○ | ○ | ○ |
| Example 13 | ◎ | 2.3 | ○ | ○ | ○ | ○ |
| Example 14 | ○ | 1.5 | ○ | ○ | ○ | ○ |
| Example 15 | ○ | 3.0 | ○ | ○ | ○ | ○ |
| Example 16 | ○ | 2.9 | ○ | ○ | ○ | ◎ |
| Example 17 | ○ | 0.9 | ○ | ○ | ○ | ◎ |

(continued)

| | Sensitivity | Optical density (OD) | Residue | Adhesive force | Straightness | Reliability |
|---|---|---|---|---|---|---|
| Example 18 | ○ | 1.2 | ○ | ○ | ○ | ◎ |
| Example 19 | ○ | 1.6 | ○ | ○ | ○ | ◎ |
| Example 20 | ○ | 1.5 | ○ | ○ | ○ | ○ |
| Example 21 | ◎ | 2.5 | ○ | ○ | ○ | ◎ |
| Example 22 | ◎ | 2.4 | ○ | ○ | ○ | ◎ |
| Example 23 | ◎ | 2.7 | ○ | ○ | ○ | ◎ |
| Example 24 | ◎ | 2.9 | ○ | ○ | ○ | ◎ |
| Example 25 | ◎ | 1.0 | ○ | ○ | ○ | ◎ |
| Example 26 | ◎ | 0.7 | ○ | ○ | ○ | ◎ |
| Example 27 | ○ | 1.9 | ○ | ○ | ○ | ◎ |
| Example 28 | ○ | 1.9 | ○ | ○ | ○ | ◎ |
| Example 29 | ○ | 2.2 | ○ | ○ | ○ | ◎ |
| Example 30 | ○ | 2.4 | ○ | ○ | ○ | ◎ |
| Comparative Example 1 | ○ | 0.9 | X | ○ | X | X |
| Comparative Example 2 | ○ | 1.9 | X | ○ | X | X |
| Comparative Example 3 | ○ | 2.2 | X | ○ | X | X |
| Comparative Example 4 | ○ | 2.4 | X | ○ | X | X |

Referring to Table 4 , it was confirmed that when forming a cured film and pattern using the photosensitive resin composition of Examples containing a predetermined alkali-soluble resin and a black pigment or mixture, various characteristics such as sensitivity, OD, residue, adhesive force, pattern straightness, and reliability were excellent.

On the other hand, it was confirmed that when using the photosensitive resin compositions of Comparative Examples 1 to 4 containing an alkali-soluble resin different from that of Examples, one or more of the various characteristics of the cured film and its pattern appeared to be inferior.

## Claims

**1.** A photosensitive resin composition comprising:

an alkali-soluble resin;
a polyfunctional compound having a plurality of photocurable unsaturated functional groups;
a pigment including a black pigment or a pigment mixture exhibiting a black color in a mixture state; and
a photoinitiator,
wherein the alkali-soluble resin is a resin having a repeating unit derived from a phenolic compound having two or more phenolic hydroxy groups, and a plurality of photocurable unsaturated functional groups at both ends of the main chain.

**2.** The photosensitive resin composition of claim 1, wherein the repeating unit derived from a phenolic compound is bonded to the photocurable unsaturated functional group through an ether (-O-) linking group.

**3.** The photosensitive resin composition of claim 1, wherein the repeating unit derived from a phenolic compound has 2 to 6 aromatic rings and 0 to 4 alicyclic rings in the molecule.

4. The photosensitive resin composition of claim 1, wherein the alkali-soluble resin includes a structure of the following General Formula 1:

[General Formula 1] (AB)-(ZBA)p-(BA)

wherein, in General Formula 1,
A is a photocurable unsaturated functional group,
each B is independently an organic group including an alkali-soluble functional group selected from the group consisting of hydrogen, a hydroxy group, an alkoxy group having 1 to 5 carbon atoms, a carbonyl group and a carboxyl group,
Z is a repeating unit derived from a phenolic compound having two or more phenolic hydroxy groups, and
P is an integer of 2 to 100.

5. The photosensitive resin composition of claim 1, wherein the alkali-soluble resin has a polystyrene converted weight average molecular weight (Mw) of 1000 or more.

6. The photosensitive resin composition of claim 1, wherein the photocurable unsaturated functional group bonded to the alkali-soluble resin or the polyfunctional compound is a (meth)acrylate-based functional group.

7. The photosensitive resin composition of claim 1, wherein the alkali-soluble resin comprises one or more selected from the group consisting of the following Chemical Formulas 1 and 2:

[Chemical Formula 1]

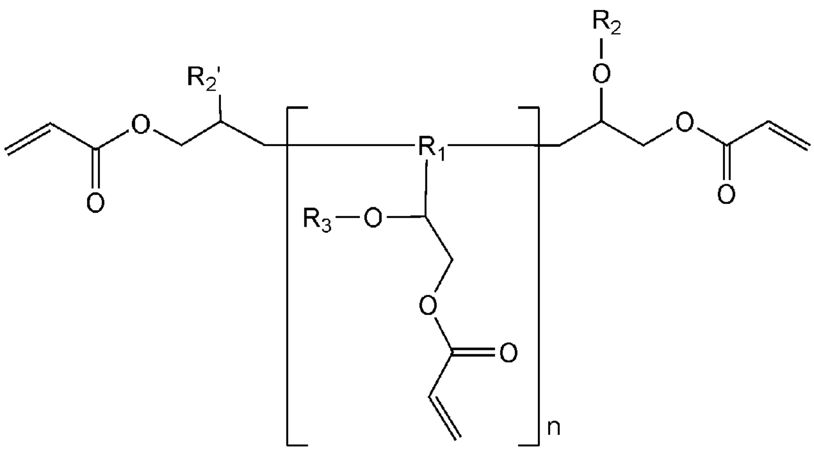

[Chemical Formula 2]

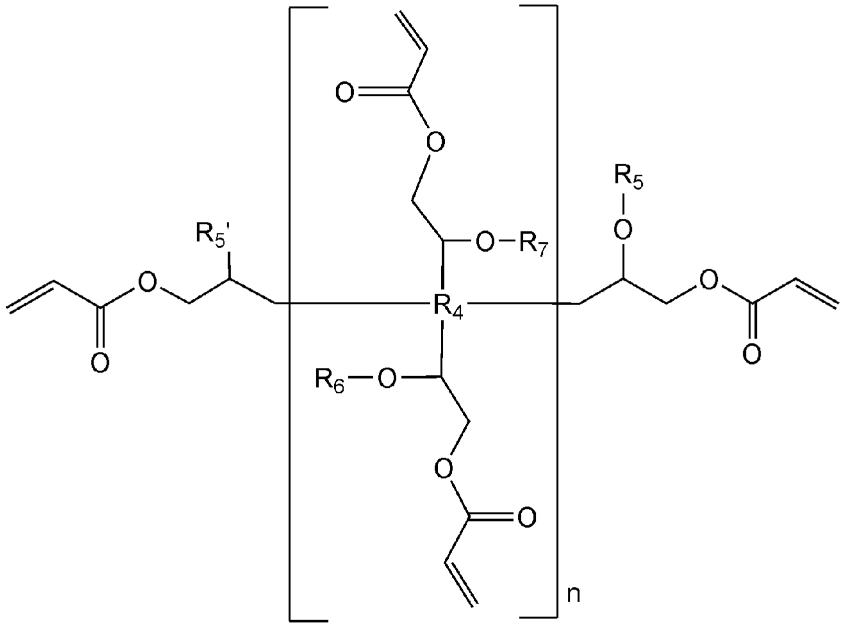

wherein, in Chemical Formulas 1 and 2,

$R_1$ and $R_4$ each independently represent a functional group derived from a phenolic compound having 3 to 8 aromatic rings or alicyclic rings in the molecule and having 3 or more phenolic hydroxy groups,

$R_2$, $R_3$, $R_5$, $R_6$ and $R_7$ each independently represent a substituent including an alkali-soluble functional group selected from the group consisting of hydrogen, a hydroxy group, an alkoxy group having 1 to 5 carbon atoms, a carbonyl group, and a carboxy group,

$R_2$' and $R_5$' are each independently hydrogen or ORs, where $R_8$ each independently represents a substituent including an alkali-soluble functional group selected from the group consisting of hydrogen, a hydroxy group, an alkoxy group having 1 to 5 carbon atoms, a carbonyl group, and a carboxyl group, and

n is the number of repetitions and represents an integer of 2 to 100.

**8.** The photosensitive resin composition of claim 7, wherein the $R_2$, $R_3$, $R_5$, $R_6$ and $R_7$ of Chemical Formulas 1 and 2 each independently include one or more alicyclic structures.

**9.** The photosensitive resin composition of claim 7, wherein the $R_1$ and $R_4$ represent a functional group derived from a phenolic compound selected from the group consisting of the following Chemical Formulas 3 to 17:

[Chemical Formula 3]

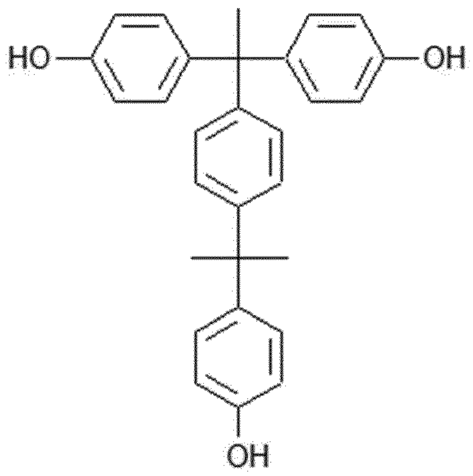

[Chemical Formula 4]

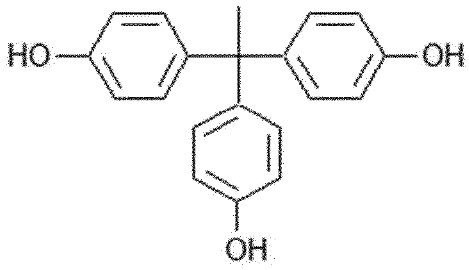

[Chemical Formula 5]

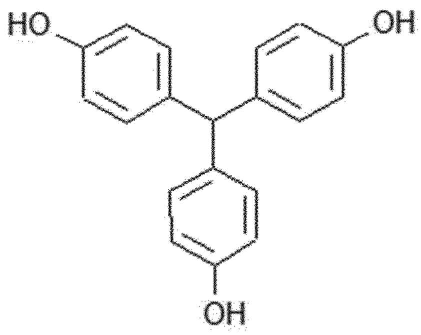

[Chemical Formula 6]

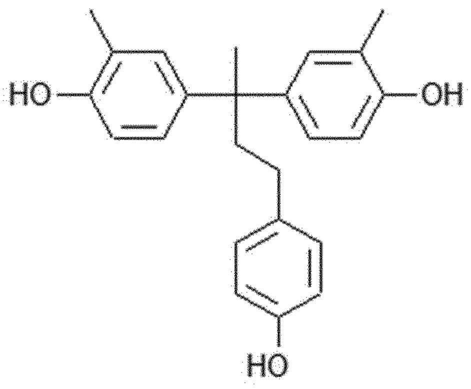

[Chemical Formula 7]

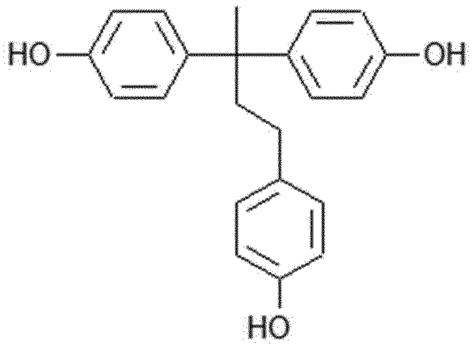

[Chemical Formula 8]

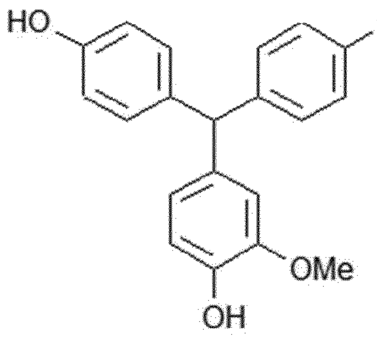

[Chemical Formula 9]

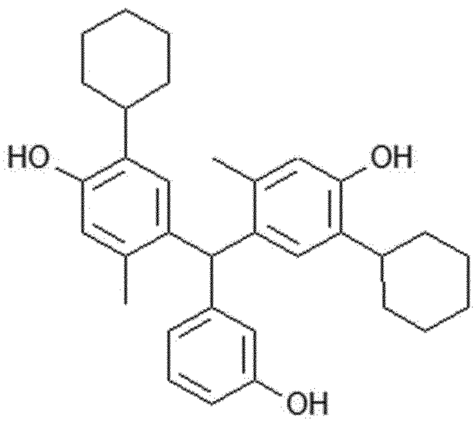

[Chemical Formula 10]

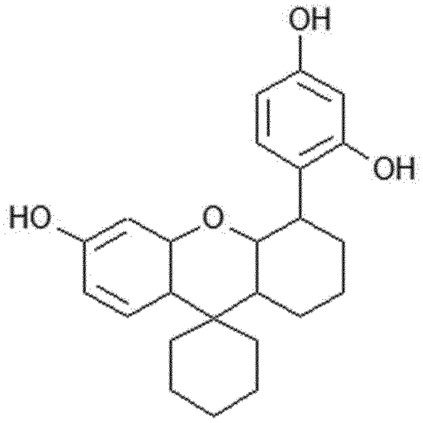

[Chemical Formula 11]

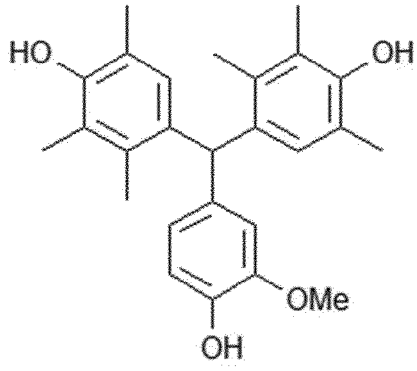

[Chemical Formula 12]

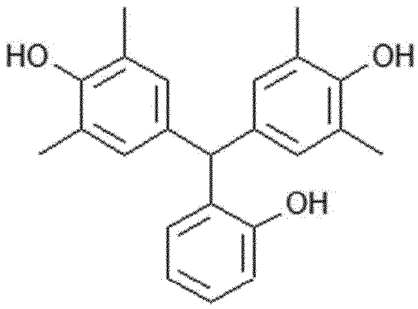

[Chemical Formula 13]

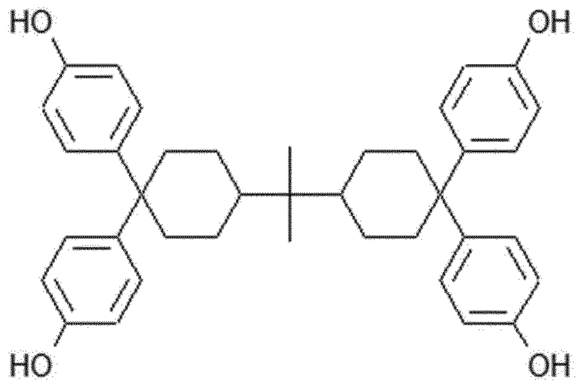

[Chemical Formula 14]

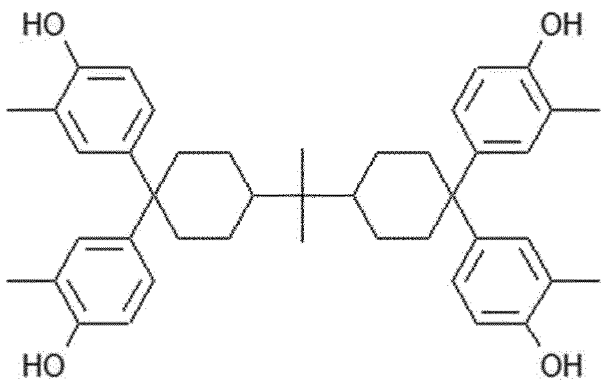

[Chemical Formula 15]

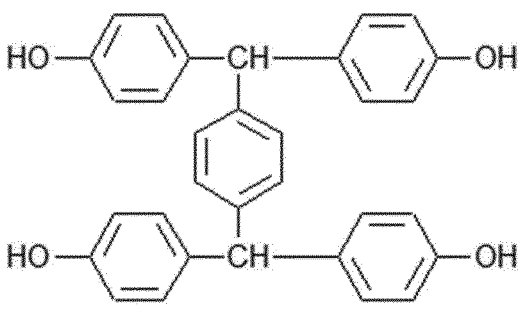

[Chemical Formula 16]

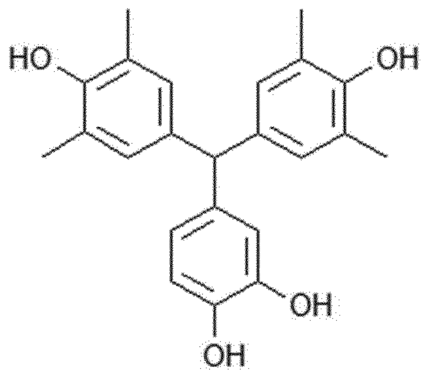

[Chemical Formula 17]

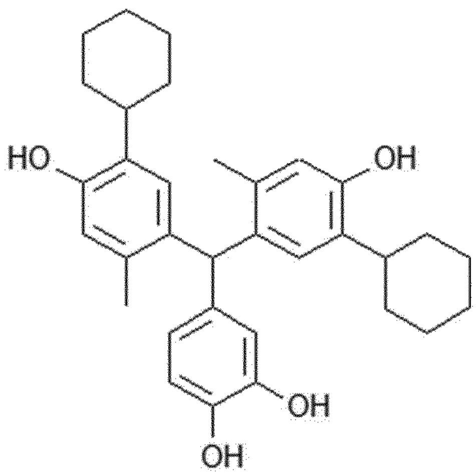

.

**10.** The photosensitive resin composition of claim 1, wherein the alkali-soluble resin comprises one or more selected from the group consisting of the following Chemical Formulas 3A to 17A:

[Chemical Formula 3A]

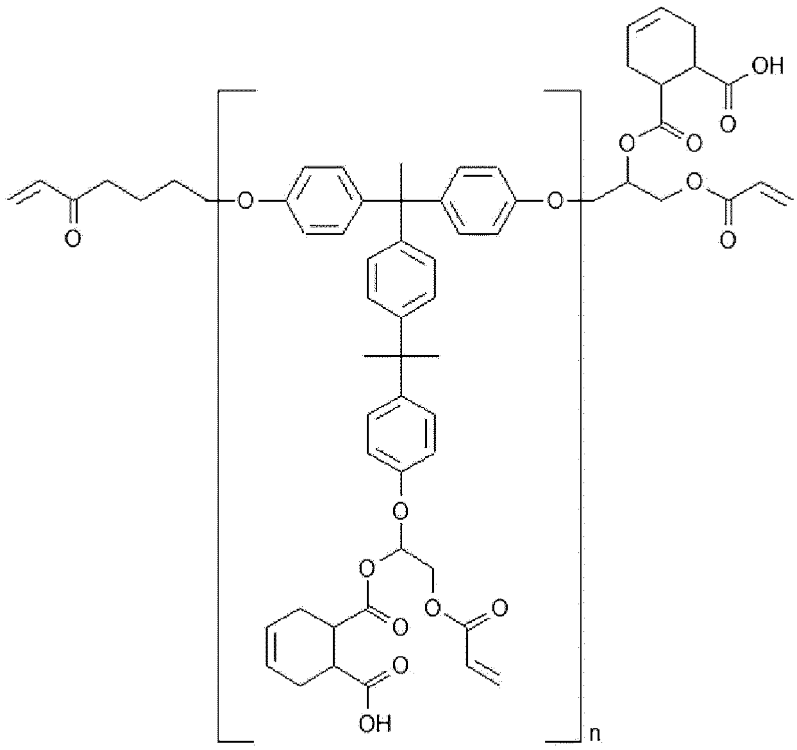

[Chemical Formula 4A]

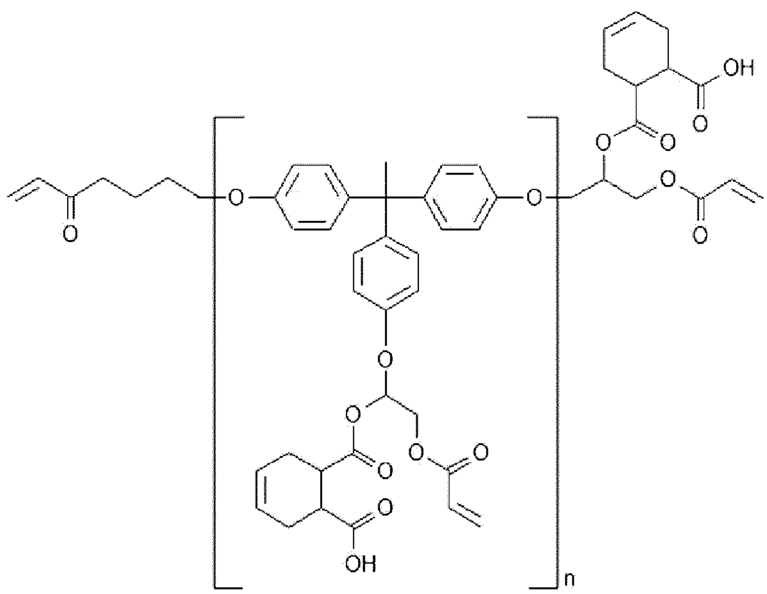

[Chemical Formula 5A]

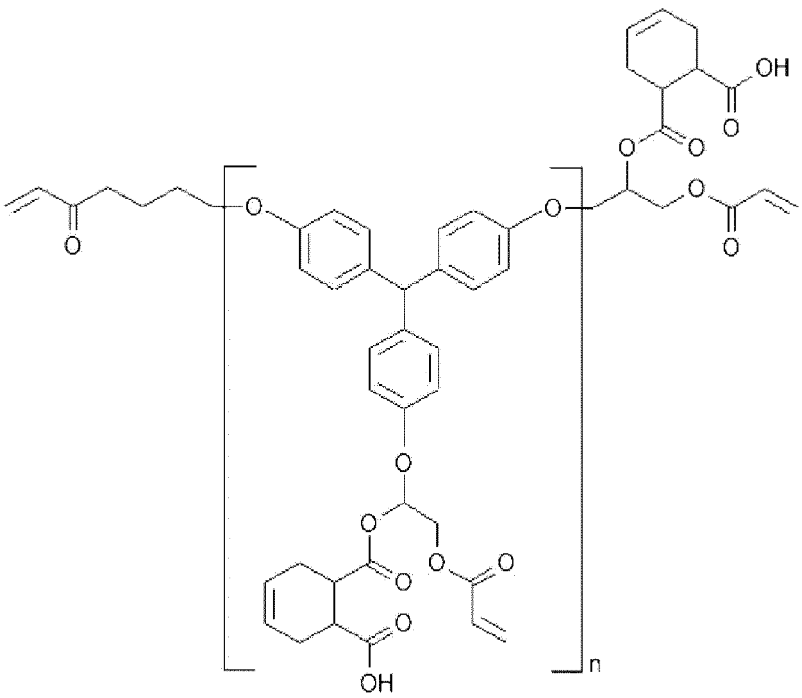

[Chemical Formula 6A]

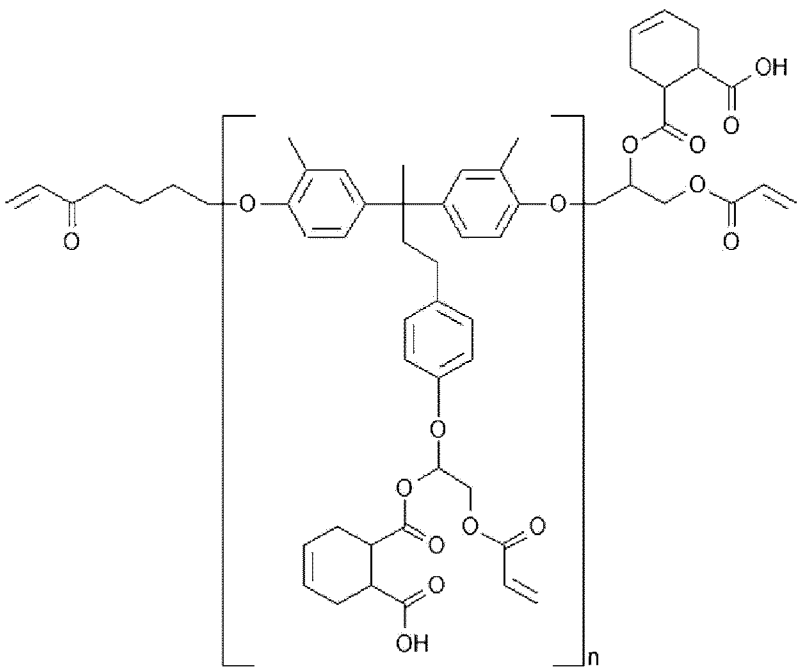

[Chemical Formula 7A]

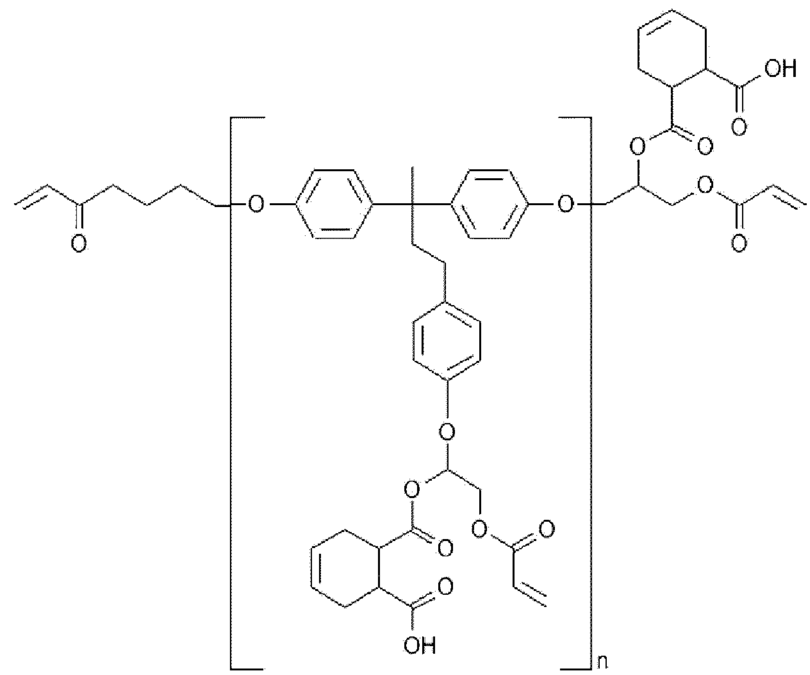

[Chemical Formula 8A]

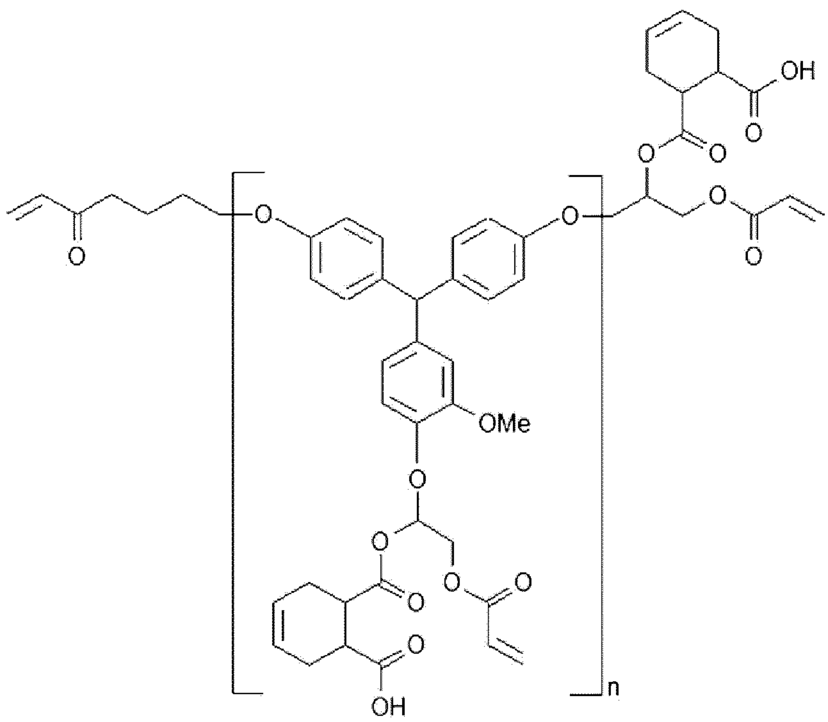

[Chemical Formula 9A]

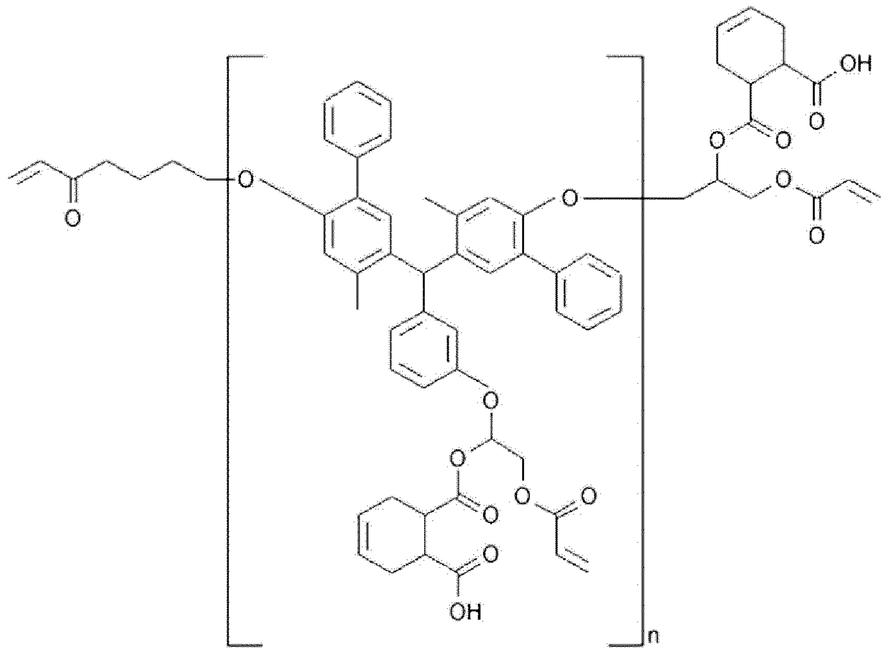

[Chemical Formula 10A]

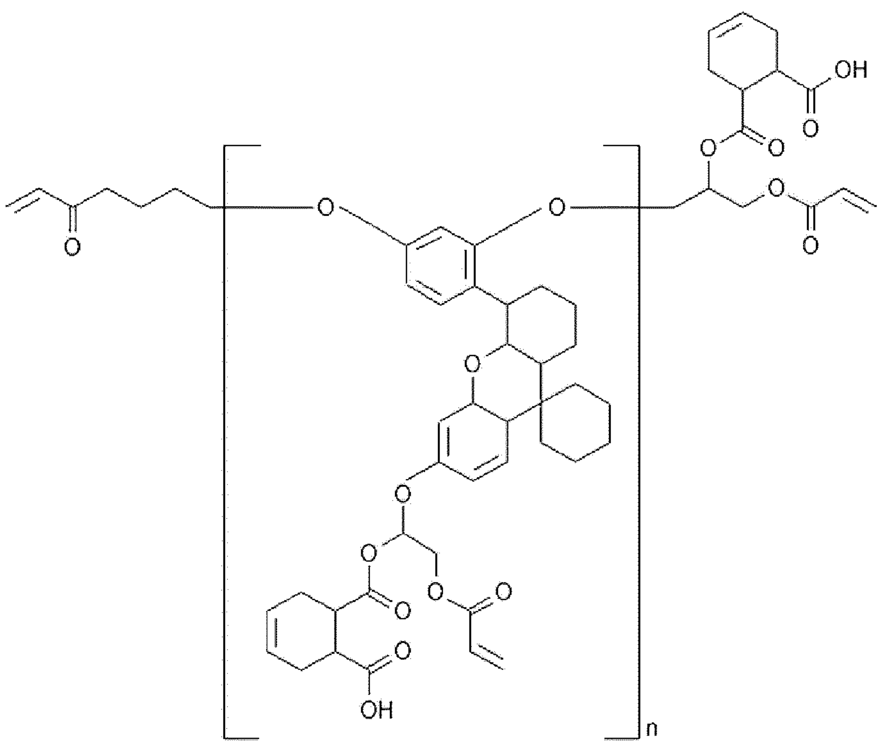

[Chemical Formula 11A]

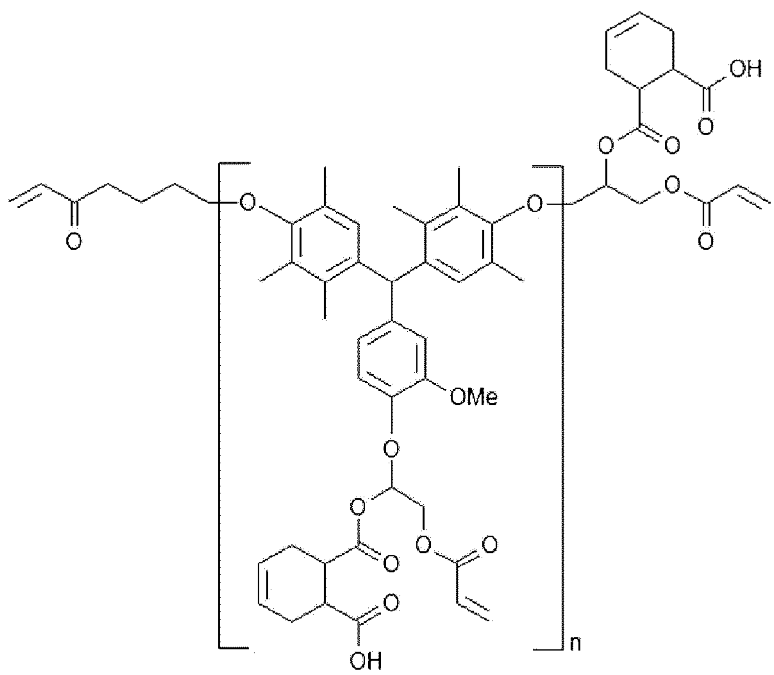

[Chemical Formula 12A]

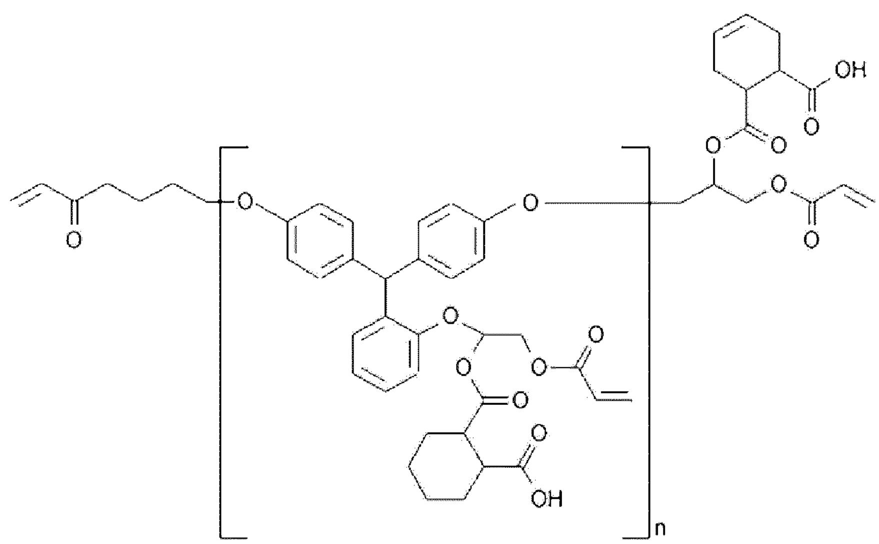

[Chemical Formula 13A]

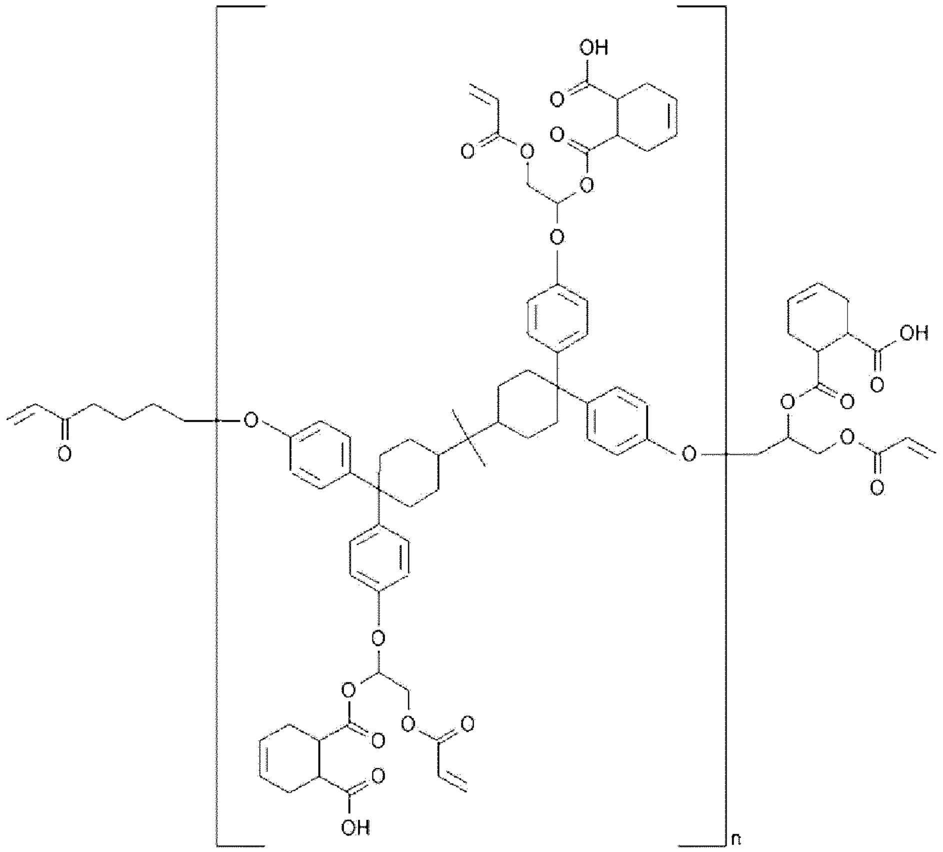

[Chemical Formula 14A]

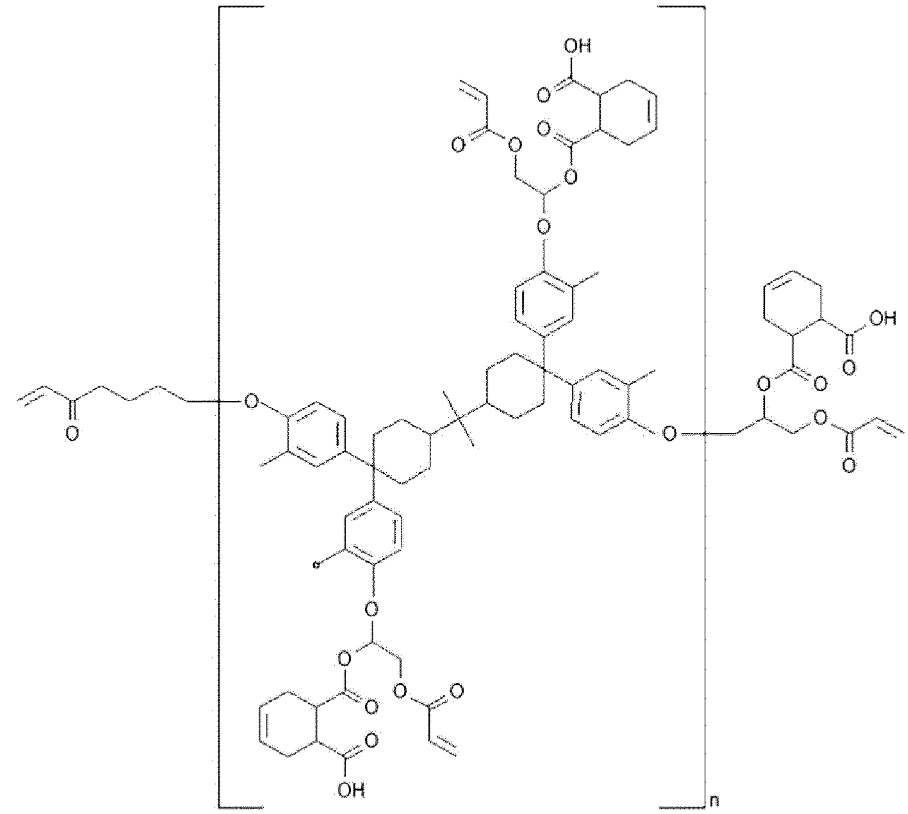

[Chemical Formula 15A]

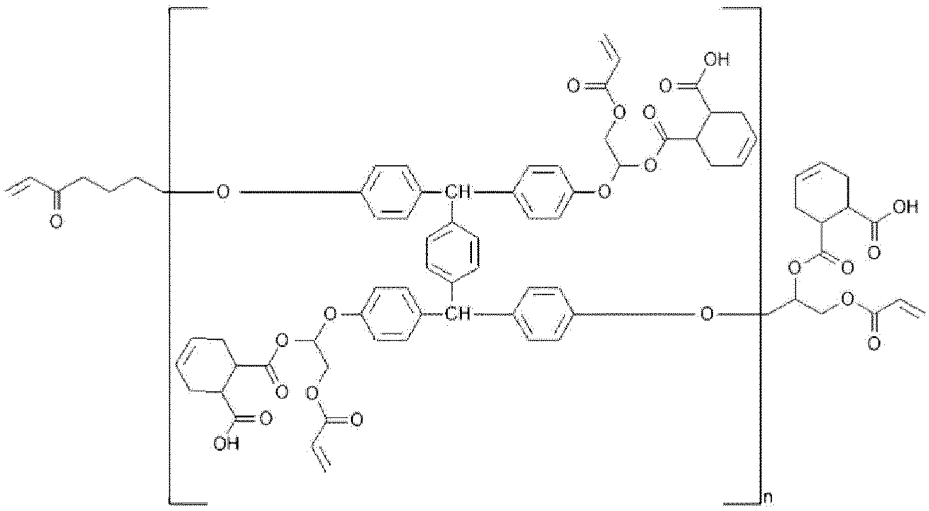

[Chemical Formula 16A]

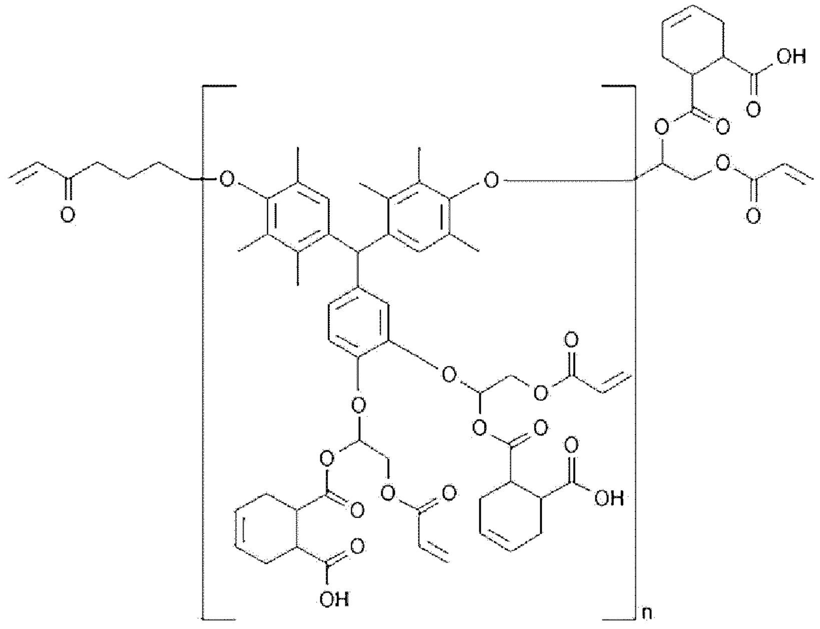

[Chemical Formula 17A]

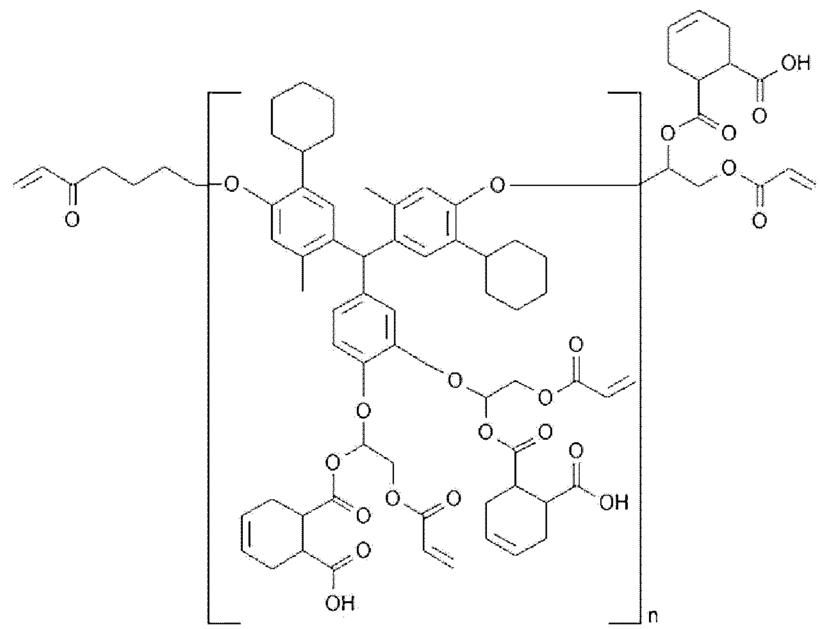

wherein, in Chemical Formula 3A to 17A, n is the number of repetitions and represents an integer of 2 to 100.

**11.** The photosensitive resin composition of claim 6, wherein the polyfunctional compound is a monomer or oligomer having 2 to 20 (meth)acrylate-based functional groups, and includes one or more selected from the group consisting of a (meth)acrylate-based compound, an aliphatic urethane (meth)acrylate-based compound, an a0romatic urethane (meth)acrylate-based compound and an epoxy (meth)acrylate-based compound.

**12.** The photosensitive resin composition of claim 1, wherein the black pigment includes one or more selected from the group consisting of aniline black, perylene black, titanium black, cyanine black, lignin black, lactam-based black, and carbon black.

**13.** The photosensitive resin composition of claim 1, wherein the pigment mixture includes two or more selected from

red pigment, blue pigment, yellow pigment, green pigment, and violet pigment, and exhibits a black color in a mixture state.

**14.** The photosensitive resin composition of claim 1, wherein the black pigment or the pigment mixture has a particle size of 100 to 200 nm.

**15.** The photosensitive resin composition of claim 1, wherein the photoinitiator includes one or more selected from the group consisting of a carbazole-based initiator, an oxime ester-based initiator, an aminoalkylphenone-based initiator and an acylphosphine oxide-based initiator.

**16.** The photosensitive resin composition of claim 1, which comprises:

45 to 100 parts by weight of the polyfunctional compound;
25 to 100 parts by weight of the pigment; and
2 to 30 parts by weight of the photoinitiator,
based on 100 parts by weight of the alkali-soluble resin.

**17.** The photosensitive resin composition of claim 1, further comprising:
a crosslinking agent having one or more crosslinking groups selected from the group consisting of an alkoxy group having 1 to 10 carbon atoms, an alkoxyalkyl group having 1 to 15 carbon atoms, a hydroxy group, an epoxy group, and an oxetanyl group.

**18.** The photosensitive resin composition of claim 17, wherein the crosslinking agent includes one or more selected from the group consisting of the following Chemical Formulas 18 to 29:

[Chemical Formula 18]

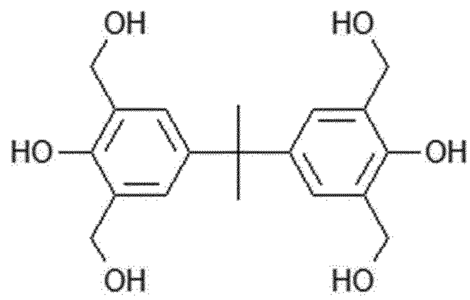

[Chemical Formula 19]

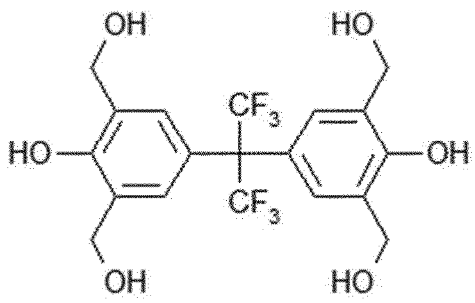

[Chemical Formula 20]

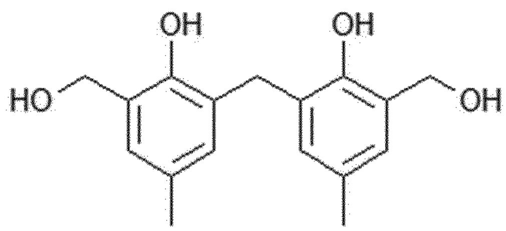

[Chemical Formula 21]

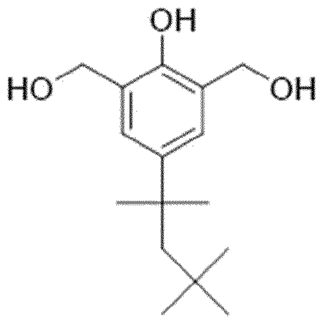

[Chemical Formula 22]

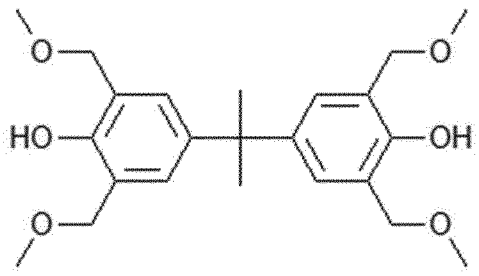

[Chemical Formula 23]

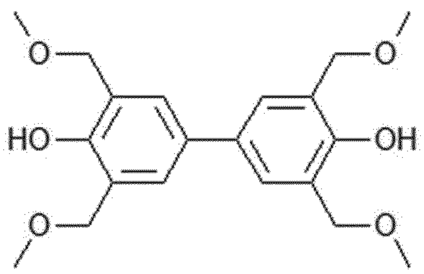

[Chemical Formula 24]

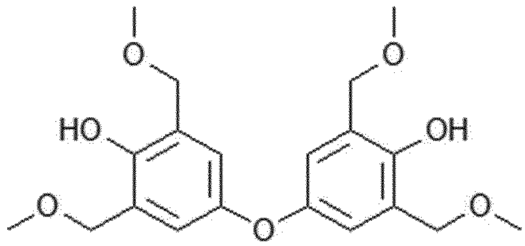

[Chemical Formula 25]

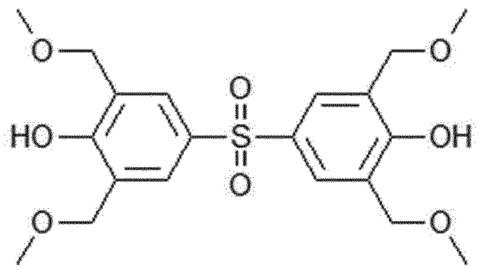

[Chemical Formula 26]

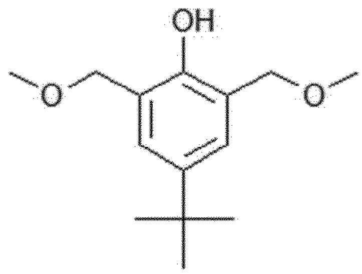

[Chemical Formula 27]

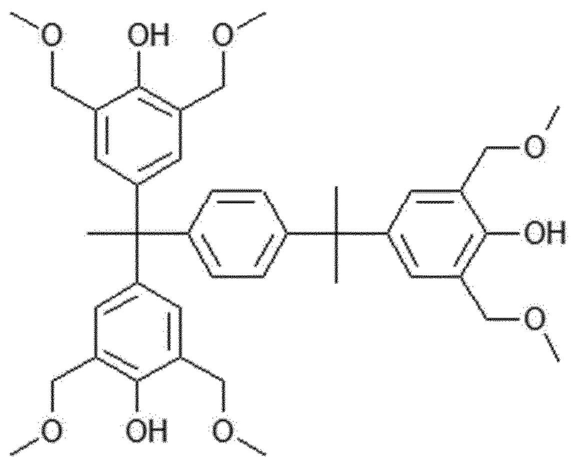

[Chemical Formula 28]

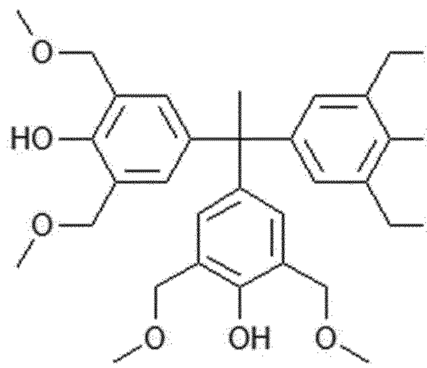

[Chemical Formula 29]

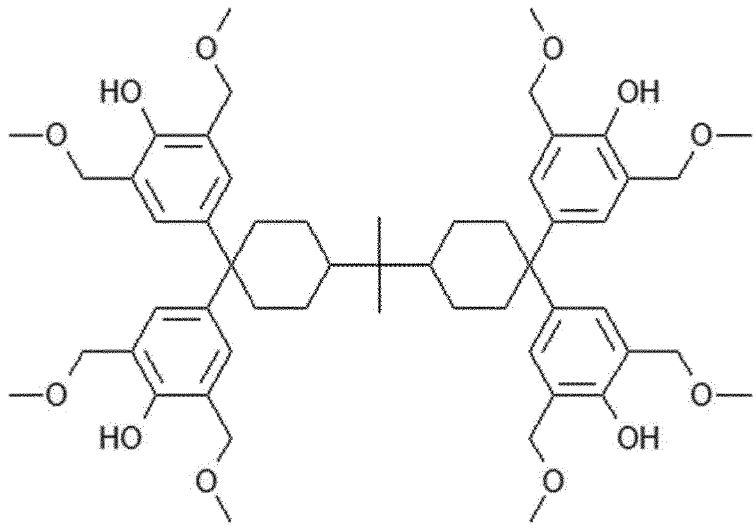

.

**19.** The photosensitive resin composition of claim 17, which comprises 0.1 to 30 parts by weight of the crosslinking agent based on 100 parts by weight of the alkali-soluble resin.

**20.** The photosensitive resin composition of claim 1, wherein the photosensitive resin composition further comprises an organic solvent and has a solid content of 10 to 50% by weight.

**21.** The photosensitive resin composition of claim 20, wherein the organic solvent includes one or more selected from the group consisting of an aromatic hydrocarbon-based solvent, an aliphatic hydrocarbon-based solvent, an ester-based solvent, an ether-based solvent, an alcohol-based solvent, an amide-based solvent, and a ketone-based solvent.

**22.** A display device comprising:

a substrate;
red, green and blue pixels defined on the substrate; and
a pixel defining layer pattern that is formed between the pixels, and includes a cured film of the photosensitive resin composition according to any one of claims 1 to 21.

**23.** The display device of claim 22, wherein the cured film has an optical density (OD) defined by the following Mathematical Equation 1 of 0.5 to 3.0:

[Mathematical Equation 1]

$$\text{Optical density (OD)} = 2 - \log T_{550}$$

wherein, in Mathematical Equation 1, $T_{550}$ represents the light transmittance (%) to 550nm light measured for a cured film having a thickness of 1$\mu$m.

**24.** The display device of claim 22, which is an organic electroluminescent device (OLED device).

【FIG. 1】

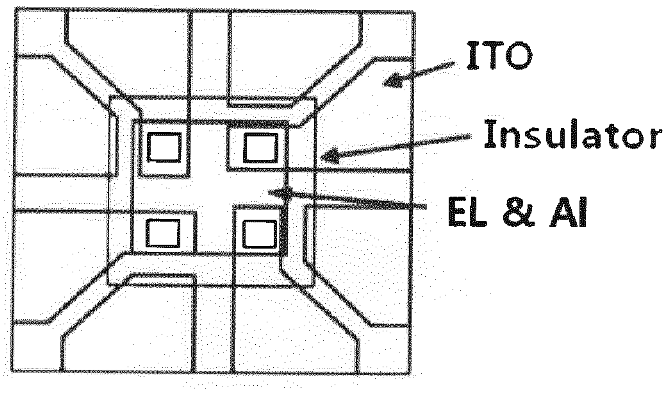

**INTERNATIONAL SEARCH REPORT**

International application No.
**PCT/KR2022/012133**

**A. CLASSIFICATION OF SUBJECT MATTER**

**G03F 7/004**(2006.01)i; **G03F 7/105**(2006.01)i; **G03F 7/028**(2006.01)i; **G03F 7/032**(2006.01)i; **G02B 5/20**(2006.01)i; **H01L 27/146**(2006.01)i

According to International Patent Classification (IPC) or to both national classification and IPC

**B. FIELDS SEARCHED**

Minimum documentation searched (classification system followed by classification symbols)

G03F 7/004(2006.01); C08F 2/50(2006.01); C08F 283/04(2006.01); C08F 283/10(2006.01); C08G 59/06(2006.01); G03F 1/32(2012.01); G03F 7/038(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 감광성(photosensitive), 알칼리 가용성 수지(alkali soluble resin), 안료(dye), 광개시제(photo-initiator), 페놀(phenol), 표시장치(display)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0125983 A (TORAY INDUSTRIES, INC.) 07 November 2019 (2019-11-07) See claims 1, 4, 11-13 and 16-20; and paragraphs [0080], [0084]-[0096], [0110], [0112]-[0127] and [0134]-[0138]. | 1-9,11-24 |
| A | | 10 |
| Y | KR 10-2014-0033120 A (NIPPON KAYAKU KABUSHIKI KAISHA) 17 March 2014 (2014-03-17) See claims 1-4; and paragraphs [0001], [0032]-[0036] and [0060]-[0067]. | 1-9,11-24 |
| Y | KR 10-2019-0130123 A (TORAY INDUSTRIES, INC.) 21 November 2019 (2019-11-21) See claims 1-22; and paragraphs [0255]-[0507]. | 1-9,11-24 |
| A | JP 2009-075261 A (NIPPON KAYAKU CO., LTD.) 09 April 2009 (2009-04-09) See claims 1-9. | 1-24 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 November 2022** | **28 November 2022** |

Name and mailing address of the ISA/KR

**Korean Intellectual Property Office**
**Government Complex-Daejeon Building 4, 189 Cheongsa-ro, Seo-gu, Daejeon 35208**

Facsimile No. **+82-42-481-8578**

Authorized officer

Telephone No.

Form PCT/ISA/210 (second sheet) (July 2022)

**INTERNATIONAL SEARCH REPORT**

International application No.
**PCT/KR2022/012133**

**C. DOCUMENTS CONSIDERED TO BE RELEVANT**

| Category* | Citation of document, with indication, where appropriate, of the relevant passages | Relevant to claim No. |
|---|---|---|
| A | US 4996270 A (CZAUDERNA, B. et al.) 26 February 1991 (1991-02-26) See claims 1-4. | 1-24 |

Form PCT/ISA/210 (second sheet) (July 2022)

**INTERNATIONAL SEARCH REPORT**
**Information on patent family members**

International application No.
**PCT/KR2022/012133**

| Patent document cited in search report | Publication date (day/month/year) | Patent family member(s) | Publication date (day/month/year) |
|---|---|---|---|
| KR 10-2019-0125983 A | 07 November 2019 | CN 110462513 A | 15 November 2019 |
| | | JP 6891880 B2 | 18 June 2021 |
| | | KR 10-2254366 B1 | 24 May 2021 |
| | | TW 201841983 A | 01 December 2018 |
| | | TW I757457 B | 11 March 2022 |
| | | US 2020-0012191 A1 | 09 January 2020 |
| | | WO 2018-180592 A1 | 04 October 2018 |
| KR 10-2014-0033120 A | 17 March 2014 | CN 103608727 A | 26 February 2014 |
| | | JP 5885269 B2 | 15 March 2016 |
| | | KR 10-1930975 B1 | 19 December 2018 |
| | | TW 201313768 A | 01 April 2013 |
| | | TW I548665 B | 11 September 2016 |
| | | US 2014-0099581 A1 | 10 April 2014 |
| | | US 9411229 B2 | 09 August 2016 |
| | | WO 2012-176750 A1 | 27 December 2012 |
| KR 10-2019-0130123 A | 21 November 2019 | CN 110392864 A | 29 October 2019 |
| | | TW 201841059 A | 16 November 2018 |
| | | US 2020-0110337 A1 | 09 April 2020 |
| | | WO 2018-181311 A1 | 04 October 2018 |
| JP 2009-075261 A | 09 April 2009 | None | |
| US 4996270 A | 26 February 1991 | DE 3520113 A1 | 11 December 1986 |
| | | EP 0207297 A1 | 07 January 1987 |
| | | EP 0207297 B1 | 04 January 1989 |

Form PCT/ISA/210 (patent family annex) (July 2022)